(19) Europäisches Patentamt
European Patent Office
Office européen des brevets

(11) **EP 3 093 836 B1**

(12) **EUROPEAN PATENT SPECIFICATION**

(45) Date of publication and mention
of the grant of the patent:
**24.06.2020 Bulletin 2020/26**

(51) Int Cl.:
***G09G 3/3233*** *(2016.01)*

(21) Application number: **16169639.8**

(22) Date of filing: **13.05.2016**

(54) **DISPLAY DEVICE AND METHOD OF REPAIRING THE SAME**

ANZEIGEVORRICHTUNG UND VERFAHREN ZUR REPARATUR DAVON

DISPOSITIF D'AFFICHAGE ET SON PROCÉDÉ DE RÉPARATION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **13.05.2015 KR 20150066760**

(43) Date of publication of application:
**16.11.2016 Bulletin 2016/46**

(73) Proprietor: **Samsung Display Co., Ltd.
Gyeonggi-do 17113 (KR)**

(72) Inventors:
• **KANG, Seong Yeun
Chungcheongnam-do (KR)**
• **PARK, Kyong Tae
Gyeonggi-do (KR)**

(74) Representative: **Mounteney, Simon James
Marks & Clerk LLP
15 Fetter Lane
London EC4A 1BW (GB)**

(56) References cited:
**EP-A2- 2 998 953      US-A1- 2015 102 312**

EP 3 093 836 B1

**Description**

BACKGROUND

Field

The invention generally relates to a display device and a method of repairing the same.

Description of the Related Technology

A display device (such as an organic light-emitting diode (OLED) display) does not require a separate light source and thus has favorable characteristics such as low power consumption and excellent refresh rate, high viewing angle, and high contrast ratio.

A display device includes a matrix of pixels such as red, blue, green, and white pixels, and can express a full color by combining the pixels. Each pixel includes light emitting element (such as an organic light-emitting diode (OLED)) and thin film transistors for driving the OLED.

Each OLED includes a pixel electrode, a common electrode, and an interposed emission layer. One of the pixel and common electrodes is an anode, and the other is a cathode. An electron injected from the cathode and a hole injected from the anode are combined in the emission layer to form an exciton, and the exciton emits light while discharging energy. The common electrode is formed throughout the pixels to transfer a predetermined common voltage.

In the display device, since a pixel is complicated and a manufacturing process is difficult, in the manufacturing process, a defective pixel can be generated. Accordingly, in order to enhance yield, a repair process which can use the defective pixel generated in the manufacturing process as a normal pixel is required.

EP 2 998 953A2, which forms part of the prior art under Art. 54(3) EPC only, discloses an organic light emitting display device in which an auxiliary line is discharged to a first power voltage using a discharge transistor.

US 2015/102312A1 discloses an organic light emitting display device in which a plurality of repair lines are connected to dummy pixels.

The above information disclosed in this Background section is only for enhancement of understanding of the background of the described technology and therefore it can contain information that does not constitute the prior art that is already known in this country to a person of ordinary skill in the art.

SUMMARY OF CERTAIN INVENTIVE ASPECTS

The invention seeks to provide a display device and a method of repairing the same. The invention also seeks to provide a method of repairing a defective pixel to be a normal pixel.

Accordingly, a first aspect of the invention provides a display device as set out in Claim 1.

Optional features of this aspect of the invention are set out in Claims 2 and 3.

Another aspect of the invention provides a method of repairing a display device as set out in Claim 4.

Optional features of this aspect of the invention are set out in Claims 5 to 8.

According to at least one of the disclosed embodiments, it is possible to repair a defective pixel.

BRIEF DESCRIPTION OF THE DRAWINGS

FIG. 1 is a block diagram of a display device according to an embodiment of the invention.
FIG. 2 is an equivalent circuit diagram exemplifying a pixel of FIG. 1.
FIG. 3 is a signal timing of the pixel of FIG. 2.
FIG. 4 is a conceptual diagram illustrating a repair procedure for a defective pixel according to the embodiment of the invention.
FIG. 5 is a circuit diagram of a defect pixel and dummy pixels of FIG. 4.
FIG. 6 is a signal timing of the defective pixel and dummy pixels of FIG. 5.
FIG. 7 is a circuit diagram of a repair procedure for a defective pixel according to another embodiment of the invention.
FIG. 8 is a circuit diagram of a repair procedure for a defective pixel according to yet another embodiment of the invention.
FIG. 9 is a block diagram illustrating a repair procedure for a defective pixel according to another embodiment of the invention.
FIG. 10 is a circuit diagram of the defective pixel and dummy pixels of FIG. 9.

FIG. 11 is a signal timing of the defective pixel and dummy pixels of FIG. 10.

DETAILED DESCRIPTION

Hereinafter, embodiments of the invention will be described in more detail with reference to the accompanying drawings. Like reference numerals refer to like elements for easy overall understanding and a duplicated description of like elements will be omitted. Further, "module" and "unit" which are suffixes for the components used in the specification are granted or mixed by considering only easiness in preparing the specification and do not have meanings or roles distinguished from each other in themselves. Further, in describing the described technology, when it is determined that the detailed description of the publicly known art related to the described technology can obscure the gist of the described technology, the detailed description thereof will be omitted. Further, the accompanying drawings are only for easily understanding the embodiments disclosed in the specification and the invention is not limited by the accompanying drawings.

Terms including an ordinary number, such as first and second, are used for describing various constituent elements, but the constituent elements are not limited by the terms. The above terms are used only to discriminate one component from the other component.

It should be understood that, when it is described that an element is "coupled" or "connected" to another element, the element can be "directly coupled" or "directly connected" to the another element or "coupled" or "connected" to the another element through a third element. In contrast, it should be understood that, when it is described that an element is "directly coupled" or "directly connected" to another element, it is understood that no element is not present between the element and the another element.

Singular expressions used herein include plurals expressions unless they have definitely opposite meanings.

In this specification, it should be understood that term "include" or "have" indicates that a feature, a number, a step, an operation, a component, a part or the combination thereof described in the specification is present, but does not exclude a possibility of presence or addition of one or more other features, numbers, steps, operations, components, parts or combinations, in advance. In this disclosure, the term "substantially" includes the meanings of completely, almost completely or to any significant degree under some applications and in accordance with those skilled in the art. Moreover, "formed on" can also mean "formed over."

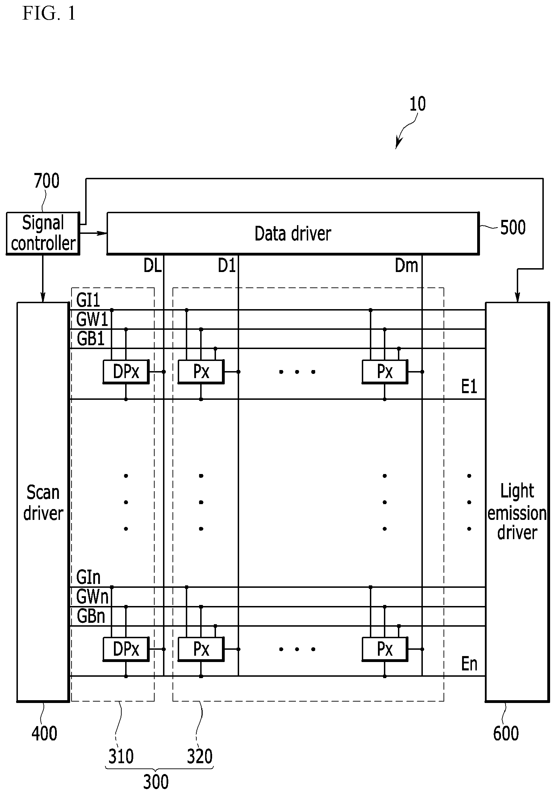

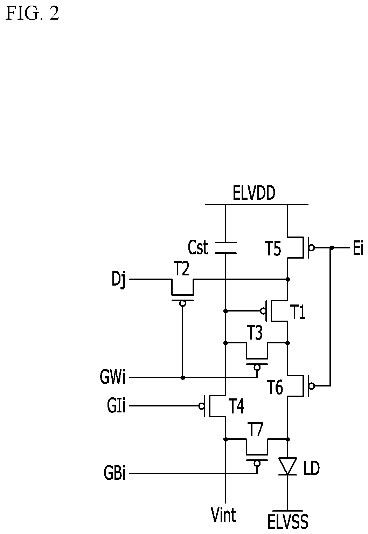

FIG. 1 is a block diagram of a display device 10 according to an embodiment of the invention. FIG. 2 is an equivalent circuit diagram exemplifying a pixel of FIG. 1.

Referring to FIG. 1, the display device 10 according to an embodiment of the invention includes a display panel 300, a scan driver 400, a data driver 500, a light emission driver 600, and a signal controller 700. Depending on embodiments, certain elements may be removed from or additional elements may be added to the display device 10 illustrated in FIG. 1. Furthermore, two or more elements may be combined into a single element, or a single element may be realized as multiple elements. This also applies to the remaining disclosed embodiments.

The display panel 300 includes a dummy area 310 and a display area 320. The dummy area 310 includes a plurality of signal lines GI1-GIn, GW1-GWn, and and a dummy signal line DL, and a plurality of dummy pixels DPx connected thereto. And the dummy area 310 includes repair modulation circuits connected to a plurality of signal lines GB1-GBn The display area 320 includes a plurality of pixels PX which is connected to the plurality of signal lines GI1-GWn, GW1-GWn, GB1-GBn, E1-En, and D1-Dm and arranged substantially in a matrix form.

The signal lines GII-GWn, GW1-GWn, GB1-GBn, E1-En, and D1-Dm include a plurality of scan lines GI1-GIn, GW1-GWn, and GB1-GBn transferring scan signals, a plurality of data lines D1-Dm transferring data signals according to an input image signal, and a plurality of light emission scan lines E1-En transferring light emission scan signals (or light emission control signals) for light emission control. The scan lines GI1-GIn, GW1-GWn, and GB1-GB extend substantially in a row direction and are substantially parallel with each other, the data lines D1-Dm extend substantially in a column direction and are substantially parallel with each other, and the light emission scan lines E1-En extend substantially in a row direction and are substantially parallel with each other. The pixels PX is formed in areas defined by the scan lines GI1-GIn, GW1-GWn, and GB1-GBnand the data lines D1-Dm, respectively.

The dummy signal line DL transfers a data signal corresponding to a pixel to be repaired and extends substantially in a column direction. The dummy pixels DPx is connected to the dummy signal line DL and connected even to the corresponding scan line and the corresponding light emission scan line among the plurality of scan lines GI1-GIn, and GW1-GWn, and the light emission scan lines E1-En.

The scan driver 400 is connected to the scan lines GI1-GIn, GW1-GWn, and GB1-GBn of the display panel 300 and applies a scan signal configured by combining a voltage turning on a switching transistor of the pixel PX and the dummy pixel DPx and a low voltage turning off the switching transistor to the scan lines GI1-GIn, GW1-GWn, and GB1-GBn.

The data driver 500 is connected to the data lines D1-Dm of the display panel 300 to apply a data signal to the data lines D1-Dm. The data driver 500 can select the data signal from the entire gray voltages related with luminance of the pixel PX and can also generate a desired data signal by dividing a predetermined number of gray voltages.

The light emission driver 600 is connected to the light emission scan lines E1-En of the display panel 300 and applies a light emission scan signal configured by combining a voltage turning on a light emission transistor of the pixel PX and the dummy pixel DPx and a low voltage turning off the light emission transistor to the light emission scan lines E1-En.

The signal controller 700 controls the scan driver 400, the data driver 500, and the light emission driver 600.

Each of the drivers 400, 500, 600, and controller 700 can be directly mounted on the display unit 300 in at least one IC chip form, mounted on a flexible printed circuit film (not illustrated) to be attached to the display unit 300 in a tape carrier package (TCP) form, or mounted on a separate printed circuit board (not illustrated).

In some embodiments, the drivers 400, 500, 600, and controller 700 are integrated on the display panel 300 together with the signal lines GI1-GIn, GW1-GWn, GB1-GBn, D1-Dm, and E1-En, a thin film transistor, and the like. Further, the drivers 400, 500, 600, and controller 700 can be integrated by a single chip, and in this case, at least one of the drivers or at least one circuit element configuring the drivers can be positioned outside the single chip.

Referring to FIG. 2, a pixel PX connected to i-th (i=1, 2, ..., n) scan lines GIi and GWi and a j-th (j=1, 2, ..., m) data line Dj includes an OLED LD, a driving transistor T1, a storage capacitor Cst, and a plurality of switching transistors T2, T3, T4, T5, T6, and T7. The pixel PX illustrated in FIG. 2 is an example of a pixel using a data voltage as a data signal.

The driving transistor T1 and the switching transistors T2-T7 have a control terminal and two input and output terminals. The driving transistor T1 and the switching transistors T2-T7 can be p-channel field effect transistors (FET) formed of amorphous silicon or polysilicon, and the control terminal and the two input and output terminals can be a gate, a source, and a drain, respectively. However, at least one of the driving transistor T1 and the switching transistors T2-T7 can be an n-channel FET. In this case, a connection relationship between the driving transistor T1, the switching transistors T2-T7, the capacitor Cst, and the OLED LD to be described below can be changed.

The control terminal of the switching transistor T2 is connected to the scan line GWi, a first input and output terminal is connected to the data line Dj, and a second input and output terminal is connected to the first input and output terminal of the driving transistor T1. The switching transistor T2 transfers a data voltage Vdata applied to the data line Dj in response to a scan signal at a low voltage applied to the scan line GWi.

The control terminal of the switching transistor T3 is connected to the scan line GWi, and the first input and output terminal and the second input and output terminal are connected to the control terminal and the second input and output terminal of the driving transistor T1, respectively. The switching transistor T3 diode-connects the driving transistor T1 in response to the scan signal at the low voltage applied to the scan line GWi.

The storage capacitor Cst is connected between the control terminal of the driving transistor T1 and a driving voltage line supplying a driving voltage ELVDD. When the switching transistors T2 and T3 are turned on in response to the scan signal at the low voltage applied to the scan line GWi, a voltage corresponding to the data voltage Vdata is charged through the diode-connected driving transistor T1. Even after the switching transistors T2 and T3 are turned off, the voltage is maintained.

A control terminal of the switching transistor T4 is connected to a first initialization scan line GIi, a first input and output terminal is connected to the control terminal of the driving transistor T1, and a second input and output terminal is connected to an initialization voltage line supplying an initialization voltage Vint. The switching transistor T4 is turned on in response to an initialization scan signal at a low voltage applied to the first initialization scan line GIi to initialize a voltage of a node where the control terminal of the driving transistor T1 and the capacitor Cst meet each other to the initialization voltage Vint.

The control terminals of the switching transistors T5 and T6 are connected to a light emission scan line Ei. In addition, the first input and output terminal of the switching transistor T5 is connected to the driving voltage line ELVDD, and the second input and output terminal is connected to the first input and output terminal of the driving transistor T1. The first input and output terminal of the switching transistor T6 is connected to the second input and output terminal of the driving transistor T1, and the second input and output terminal is connected to the OLED LD. The switching transistors T5 and T6 are turned on in response to a light emission scan signal at a low voltage applied to the light emission scan line Ei to form a current path between the driving voltage line ELVDD, the driving transistor T1, and the OLED LD. Accordingly, the driving transistor T1 runs an output current of which amplitude varies according to a voltage applied between the control terminal and the first input and output terminal, that is, a voltage charged in the capacitor Cst.

The OLED LD can have an anode connected to the second input and output terminal of the switching transistor T6 and a cathode connected to the common voltage ELVSS. The OLED LD emits light by varying the intensity according to the output current of the driving transistor T1 to display an image.

The OLED LD can emit light of one of the primary colors. As an example of the primary colors, three primary colors of red, green, and blue can be included, and a desired color is displayed in a spatial sum or a temporal sum of the three primary colors. In this case, some OLEDs LD can emit white light, and as a result, luminance is increased. In some embodiments, the OLEDs LD of all of the pixels PX emit white light, and some pixels PX further include color filters (not illustrated) changing the white light emitted from the OLEDs LD into any one of the primary color light.

In this case, a pixel bundle displaying a desired color can include three pixels displaying red, green, and blue, respectively, or can further include a pixel displaying white.

The control terminal of the switching transistor T7 is connected to a second initialization scan line GBi, the first input and output terminal is connected to the initialization voltage line Vint, and the second input and output terminal is connected to the second input and output terminal of the switching transistor T6, that is, an anode of the OLED LD. The switching transistor T7 is turned on in response to the initialization scan signal at the low voltage applied to the second initialization scan line GBi to initialize an anode voltage of the OLED LD to the initialization voltage Vint.

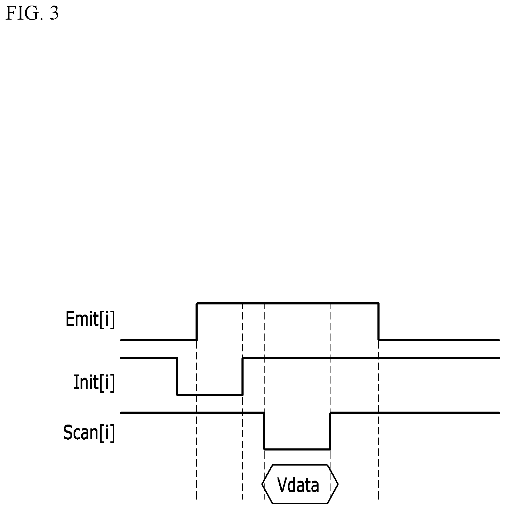

Next, driving of the display device according to the embodiment of the invention will be described with reference to FIG. 3.

FIG. 3 is a signal timing of the pixel of FIG. 2.

Referring to FIGS. 1 to 3, while a light emission scan signal Emit[i] at a high voltage Vgh is applied to the light emission scan line Ei, an initialization scan signal Init[i] at a low voltage Vgl is applied to the first initialization scan line GIi and the second initialization scan line GBi. Then, the switching transistor T4 is turned on and a node where the control terminal of the driving transistor T1 and the capacitor Cst meet each other is initialized with the initialization voltage Vint. Further, the switching transistor T7 is turned on and then a node where the anode of the OLED LD and the switching transistor T6 meet each other is initialized with the initialization voltage Vint. Accordingly, the voltage of the capacitor Cst and the voltage charged in a parasitic capacitance component (hereinafter, referred to as a parasitic capacitor) of the OLED LD can be initialized. For convenience of description, the initialization scan signal Init[i] is substantially simultaneously (or concurrently) applied to the first initialization scan line GIi and the second initialization scan line GBi, but the embodiment of the invention is not limited thereto.

Next, while the light emission scan signal Emit[i] at the high voltage Vgh is applied to the light emission scan line Ei, the first initialization scan signal Init[i] of the first initialization scan line GIi is converted into the high voltage Vgh and a scan signal Scan[i] at a low voltage Vgl is applied to the scan line GWi. Then, the switching transistor T3 is turned on and then the driving transistor T1 is diode-connected. Further, the switching transistor T2 is turned on and then the data voltage Vdata from the data line Dj is transferred to the first input and output terminal of the driving transistor T1. In this case, when a threshold voltage of the diode-connected driving transistor T1 is Vth, a (Vdata-Vth) voltage is applied to the control terminal of the driving transistor T1. Accordingly, a [ELVDD-(Vdata-Vth)] voltage is stored in the capacitor Cst.

Next, the scan signal Scan[i] of the scan line GWi is converted to the high voltage Vgh, and the light emission scan signal Emit[i] of the light emission scan line Ei is converted to the low voltage Vgl. Accordingly, the switching transistors T5 and T6 are turned on and then a current $I_{LD}$ from the driving transistor T1 flows to the OLED LD and the OLED LD emits light with brightness corresponding to the current. In this case, since the current $I_{LD}$ from the driving transistor T1 is determined like Equation 1, the current $I_{LD}$ is not influenced by a deviation of the threshold voltage of the driving transistor T1.

[Equation 1]

$$I_{LD}=\beta/2(Vgs-Vth)^2=\beta/2((ELVDD-(Vdata-Vth)-Vth))^2=\beta/2(ELVDD-Vdata)^2$$

Here, Vgs is a gate-source voltage difference of the driving transistor T1, and $\beta$ is a parameter determined according to a characteristic of the driving transistor T1.

In any embodiment of the invention, the first initialization scan line GIi is not connected to the control terminals of the switching transistors T4 and T7 of the pixel PX, but a previous scan line [S(i-1)] can be connected. Then, the switching transistors T4 and T7 can be turned on in response to a low voltage of the scan signal Scan[i-1] of the previous scan line [S(i-1)] which is applied before the scan signal Scan[i] of the scan line GWi. In another embodiment of the invention, different signal lines are also connected to the control terminal of the switching transistor T4 and the control terminal of the switching transistor T7.

Hereinafter, a defective pixel repair according to this embodiment will be described.

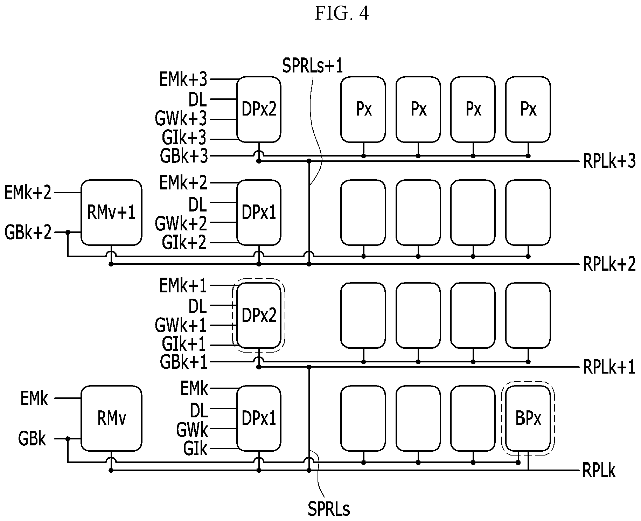

FIG. 4 is a conceptual diagram illustrating a repair procedure for a defective pixel according to the embodiment of the invention.

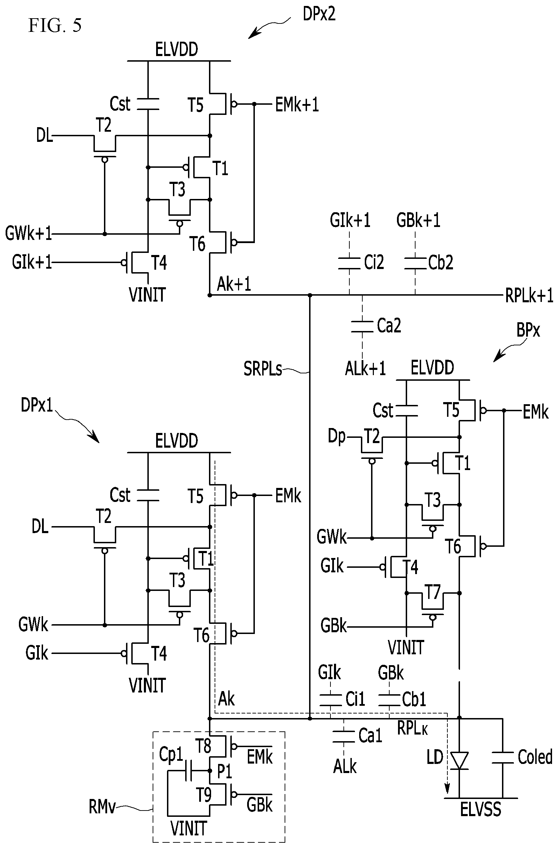

FIG. 5 is a circuit diagram of the defect pixel and dummy pixels of FIG. 4.

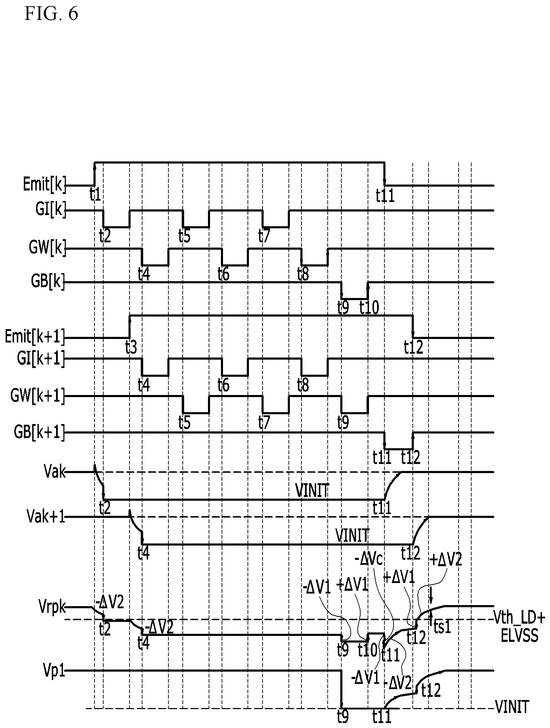

FIG. 6 is a signal timing of the defective pixel and dummy pixels of FIG. 5.

Referring to FIG. 4, a plurality of dummy pixels DPx1 and a plurality of dummy pixels DPx2 are respectively connected to a plurality of corresponding repair lines among a plurality of repair lines RPLk, RPLk+1, RPLk+2, and RPLk+3. Each of a plurality of repair modulation circuits RMv and RMv+1 is connected to each of the dummy pixels DPx2.

Each of the plurality of dummy pixels DPx1 and the plurality of dummy pixels DPx2 is connected to each of a plurality of sub repair lines SRPLs and SRPLs+1. Further, the dummy pixel DPx1 connected to the repair line RPLk and the dummy pixel DPx2 connected to the repair line RPLk+1 share the repair modulation circuit RMv. The dummy pixel DPx1 connected to the repair line RPLk+2 and the dummy pixel DPx2 connected to the repair line RPLk+3 share the repair modulation circuit RMv+2.

The pixels PX and a defective pixel BPX are respectively connected to second corresponding initialization lines among a plurality of second initialization lines GBk, GBk+1, GBk+2, and GBk+3.

The dummy pixel DPx1 according to the embodiment of the invention can be a pixel circuit driving a red or blue OLED LD, and the second dummy pixel DPx2 can be a pixel circuit driving a green OLED LD, but the embodiment of the invention is not limited thereto.

The dummy pixel DPx1 connected to the repair line RPLk is connected to the light emission scan line EMk, the dummy signal line DL, the scan line GWk, and the first initialization scan line GIk.

The repair modulation circuit RMv is connected to the repair line RPLk, the light emission scan line EMk, and the second initialization scan line GBk.

The dummy pixel DPx2 connected to the repair line RPLk+1 is connected to the light emission scan line EMk+1, the dummy signal line DL, the scan line GWk+1, and the initialization scan line GIk+1.

The dummy pixel DPx1 connected to the repair line RPLk+2 is connected to the repair line RPLk+2, the light emission scan line EMk+2, the dummy signal line DL, the scan line GWk+2, and the initialization scan line GIk+2.

The repair modulation circuit RMv+1 is connected to the repair line RPLk+2, the light emission scan line EMk+2, and the second initialization scan line GBk+2.

The dummy pixel DPx2 connected to the repair line RPLk+3 is connected to the light emission scan line EMk+3, the dummy signal line DL, the scan line GWk+3, and the initialization scan line GIk+3.

Hereinafter, a repairing method of the defective pixel BPX by connecting the defective pixel BPX with the dummy pixel DPx2 and using the dummy pixel DPxl, the repair modulation circuit RMv, and the dummy pixel DPx2 will be described with reference to FIG. 5.

Referring to FIG. 5, the dummy pixel DPx1 and the dummy pixel DPx2 include dummy pixel driving circuits.

The dummy pixel driving circuit of the dummy pixel DPx1 includes the driving transistor T1, the capacitor Cst, and the switching transistors T2, T3, T4, T5, and T6.

The dummy pixel driving circuit of the dummy pixel DPx2 includes the driving transistor T1, the capacitor Cst, and the switching transistors T2, T3, T4, T5, and T6.

The repair modulation circuit RMv includes switching transistors (or initialization transistors) T8 and T9 and a capacitor (or initialization capacitor) Cp1.

The driving transistor T1, the capacitor Cst, and the switching transistors T2, T3, T4, T5, and T6 of the dummy pixel driving circuit of the dummy pixel DPx1 and the driving transistor T1, the capacitor Cst, and the switching transistors T2, T3, T4, T5, and T6 of the dummy pixel driving circuit of the dummy pixel DPx2 are connected to each other like the corresponding configuration of the driving transistor T1, the capacitor Cst, and the switching transistors T2, T3, T4, T5, and T6 of the pixel Px illustrated in FIG. 2.

The control terminal of the switching transistor T2 of the dummy pixel DPx1 is connected to the scan line GWk. The control terminal of the switching transistor T3 is connected to the scan line GWk.

The control terminal of the switching transistor T4 of the dummy pixel DPx1 is connected to the first initialization scan line GIk, and the second input and output terminal of the switching transistor T6 is connected to a node Ak.

The control terminal of the switching transistor T2 of the dummy pixel DPx2 is connected to the scan line GWk+1. The control terminal of the switching transistor T3 is connected to the scan line GWk+1.

The control terminal of the switching transistor T4 of the dummy pixel DPx2 is connected to the first initialization scan line GIk+1, and the second input and output terminal of the switching transistor T6 is connected to a node Ak+1.

The control terminal of the switching transistor T8 is connected to the light emission signal line EMk. The first input and output terminal is connected to a connection node Ak of the repair line RPLk and the second input and output terminal of the sixth switching transistor T6. The second input and output terminal is connected to a connection node P1 of the capacitor Cpl and the switching transistor T9.

The control terminal of the switching transistor T9 is connected to the second initialization scan line GBk, the first input and output terminal is connected to the connection node P1. The second input and output terminal is connected to the initialization voltage line supplying an initialization voltage VINIT

One terminal of the capacitor Cpl is connected to the node P1, and the other terminal is connected to the initialization voltage line supplying the initialization voltage VINIT.

The repair line RPLk is connected to the anode of the OLED LD of the defective pixel BPX, and the node Ak and the node Ak+1 are connected to each other through the sub repair line SRPLs.

Referring to FIG. 5, when a defective is generated in a pixel BPX connected to a k-th scan line GWk and a p-th data line Dp, a line between the anode of the OLED LD of the defective pixel BPX and the switching transistor T6 is disconnected, and the anode of the OLED LD of the defective pixel BPX and the node Ak are connected to each other with the repair line RPLk. In addition, the data signal supplied from the data line Dp is transferred to the dummy signal line DL. Then, the OLED LD of the defective pixel BPX can normally emit light by the current transferred from the driving transistor T1 of the dummy pixel DPx1.

Further, a data signal corresponding to a black gray is applied to the first input and output terminal of the switching transistor T2 of the dummy pixel DPx2 through the dummy signal line DL and thus the current transferred from the transistor T1 is about 0 A.

In this case, a parasitic capacitor Ca1 can be formed by the repair line RPLk and the anode line ALk of normal pixels PX (see FIG. 4) of a k-th line (the same line as the defective pixel BPX). A parasitic capacitor Ci1 can be formed by the repair line RPLk and the first initialization scan line GIk connected to the control terminal of the transistor T4 of the defective pixel BPX. A parasitic capacitor Cb1 can be formed by the repair line RPLk and the second initialization scan line GBk connected to the control terminal of the transistor T9 of the repair modulation circuit RMv.

Further, a parasitic capacitor Ca2 can be formed by the repair line RPLk+1 and the anode line ALk+1 of normal pixels PX (see FIG. 4) of a k+1-th line. A parasitic capacitor Ci2 can be formed by the repair line RPLk+1 and the first initialization scan line GIk+1 connected to the control terminal of the transistor T4 of normal pixels PX (see FIG. 4) of the k+1-th line. A parasitic capacitor Cb2 can be formed by the repair line RPLk+1 and the second initialization scan line GBk+1 connected to the control terminal of the switching transistor T7 of normal pixels PX (see FIG. 4) of the k+1-th line.

Referring to FIG. 6, at a time t1, when the light emission signal Emit[k] is converted from the low voltage Vgl to the high voltage Vgh, the switching transistors T5 and T6 of the defective pixel BPX are turned off. Then, a voltage charged in a parasitic capacitor Coled of the OLED LD of the defective pixel BPX is reduced and thus an anode voltage Vak is reduced. In this case, the anode voltage Vak is a representative anode voltage of the pixels PX (see FIG. 4) positioned in a k-th row.

Further, the switching transistors T5 and T6 of the dummy pixel DPx1 and the switching transistor T8 of the repair modulation circuit RMv are turned off, and as a result, the voltage charged in a parasitic capacitor Coled of the OLED LD of the defective pixel BPX is reduced and thus a voltage Vrpk of the repair line RPLk is reduced.

At a time t2, the first initialization signal GI[k] is converted from the high voltage Vgh to the low voltage Vgl and thus the reduced anode voltage Vak is initialized with the initialization voltage VINIT. Thereafter, until a time t11 when the light emission signal Emit[k] is converted from the high voltage Vgh to the low voltage Vgl, the anode voltage Vak is maintained as the initialization voltage VINIT.

Further, the control terminal voltage of the driving transistor T1 of the dummy pixel DPx1 is initialized with the initialization voltage VINIT. Accordingly, the voltage Vrpk of the repair line RPLk is reduced by the parasitic capacitor Ci1 formed by the first initialization scan line GIk. For example, the voltage Vrpk is reduced by $\Delta V2$ voltage which is a voltage corresponding to approximately ELVSS+Vth_LD.

At a time t3, when the light emission signal Emit[k+1] is converted from the low voltage Vgl to the high voltage Vgh, the switching transistors T5 and T6 of the dummy pixel DPx2 and the switching transistors T5 and T6 of all pixels in the k+1-th row are turned off, and the voltage charged in the parasitic capacitor Coled of the OLED of all pixels in the k+1-th row is reduced. As a result, the anode voltage Vak+1 and the voltage Vrpk+1 of the repair line RPLk+1 are reduced.

At a time t4, the first initialization signal GI[k+1] is converted from the high voltage Vgh to the low voltage Vgl and thus a control terminal voltage of the driving transistor T1 of the dummy pixel DPx2 is initialized with the initialization voltage VINIT. Accordingly, the voltage Vrpk+1 of the repair line RPLk+1 is also reduced by $\Delta V2$ voltage by the parasitic capacitor Ci2 formed by the first initialization scan line GIk+1.

Further, the anode voltage Vak+1 is initialized with the initialization voltage VINIT. Thereafter, until a time t12 when the light emission signal Emit[k+1] is converted from the high voltage Vgh to the low voltage Vgl, the anode voltage Vak+1 is maintained as the initialization voltage VINIT.

In addition, the data signal supplied from the data line Dp is transferred to the dummy signal line DL.

At a time t5, a data signal of a black gray is transferred to the dummy pixel DPx2 through the dummy signal line DL.

At the times t2, t5, and t7, the voltage of the initialization scan signal GI[k] is repeatedly converted from the high voltage Vgh to the low voltage Vgl, and at the times t4, t6, and t8, the voltage of the scan signal GW[k] is repeatedly converted from the high voltage Vgh to the low voltage Vgl.

At the times t4, t6, and t8, the voltage of the initialization scan signal GI[k+1] is repeatedly converted from the high voltage Vgh to the low voltage Vgl, and at the times t5, t7, and t9, the voltage of the scan signal GW[k+1] is repeatedly converted from the high voltage Vgh to the low voltage Vgl.

When a black image or a white image is displayed and driven for a long time, a level of the voltage applied to the driving transistor T1 is continued to prevent a hysteresis phenomenon.

At a time t9, the second initialization signal GB[k] applied to the normal pixel PX (see FIG. 4) in the k-th row is converted from the high voltage Vgh to the low voltage Vgl. When the initialization signal GB[k] is reduced to the low voltage Vgl, the switching transistor t9 of the repair modulation circuit RMv is turned on and the capacitor Cpl is initialized with the initialization voltage VINIT. In this case, the voltage Vrpk+1 of the repair line RPLk+1 is reduced by $\Delta V1$ voltage

by the parasitic capacitor Cb1 formed by the second initialization scan line GBk. Further, the voltage Vpl of the node P1 is reduced to the initialization voltage VINIT.

At a time t10, the second initialization signal GB[k] is increased to the high voltage Vgh and thus the voltage Vrpk of the repair line RPLk can be increased by ΔV1 voltage by the parasitic capacitor Cbl.

At a time t11, the second initialization signal GB[k+1] applied to the normal pixel PX (see FIG. 4) in the k+1-th row is converted from the high voltage Vgh to the low voltage Vgl. In this case, the voltage Vrpk of the repair line RPLk can be reduced by ΔV1 voltage by the parasitic capacitor Cb2 formed by the second initialization scan line GBk+1.

Further, the light emission signal Emit[k] is converted to the lower voltage. Then, the driving current corresponding to the data signal supplied from the data line Dp to the dummy signal line DL is output from the driving transistor T1 of the dummy pixel DPx1 to the repair line RPLk. A part of the current output from the driving transistor T1 of the dummy pixel DPx1 is used to compensate for the voltage of the capacitor Cpl initialized with the initialization voltage VINIT. Charges charged in the parasitic capacitors Cil, Cb1, and Coled move to the capacitor Cpl by charge sharing of the capacitor Cpl of the parasitic capacitors Cil, Cbl, and Coled and thus the voltage Vprr of the repair line RPLr is reduced by ΔVc.

Further, in the defective pixel BPX, the current is supplied to the driving transistor T1 to charge the parasitic capacitor Coled of the OLED LD, and thus the anode voltage Var of the OLED LD is increased. As a result, the voltage Vrpr of the repair line RPLr can be increased by ΔV2 voltage by the parasitic capacitor Cal. In this case, the voltage Vpl of the node P1 is increased according to the voltage Vrpk of the repair line RPLk by the turned-on switching transistor T8.

At a time t12, the second initialization signal GB[k+1] is converted from the low voltage Vgl to the high voltage Vgh. As a result, the voltage Vrpk+1 of the repair line RPLk+1 can be increased by ΔV1 voltage by the parasitic capacitor Cb2.

Further, in the dummy pixel DPxl, the current is supplied through the driving transistor T1 to charge the parasitic capacitor Coled of the OLED LD, and thus the anode voltage Vak+1 of the OLED LD is increased. As a result, the voltage Vrpk+1 of the repair line RPLk+1 can be increased by ΔV2 voltage by the parasitic capacitor Ca2. In this case, the voltage Vpl of the node P1 is increased according to the voltage Vrpk of the repair line RPLk by the turned-on switching transistor T8. Since the second initialization signal GB[k+1] is reduced to the low voltage Vgl, the voltage Vrpk+1 of the repair line RPLk+1 can be reduced by ΔV1 voltage by the parasitic capacitor Cb2 formed by the second initialization scan line GBk+1.

Further, the light emission signal Emit[k+1] is converted to the lower voltage. As a result, the current is supplied through the driving transistor T1 of a dummy pixel DPx_2 and thus the anode voltage Vak+1 is increased. As a result, the voltage Vrpk of the repair line RPLk can be increased by ΔV2 voltage by the parasitic capacitor Ca2. In this case, the voltage Vpl of a node P2 is increased according to the voltage Vrpk of the repair line RPLk.

Meanwhile, after a time tsl when the charge sharing is completed, the parasitic capacitor Coled of the OLED LD of the defective pixel BPX and the parasitic capacitor Ca1 of the repair line RPLk are charged by a part of the current output from the driving transistor T1 of the dummy pixel, and thus the voltage Vrpk of the repair line RPLk is increased by the voltage corresponding to the low gray.

As such, according to the embodiment of the invention described with reference to FIGS. 4 to 6, a part of the current output from the driving transistor T1 is used to compensate for the voltage reduced by the charge sharing of the capacitor Cpl and the parasitic capacitors Cil, Cbl, and Coled, an effect due to a boosting caused by the parasitic capacitors Ci1, Cb1, and Coled can be reduced.

Further, a potential of the node P1 can be the same as a potential Vrpk of the repair line RPLk.

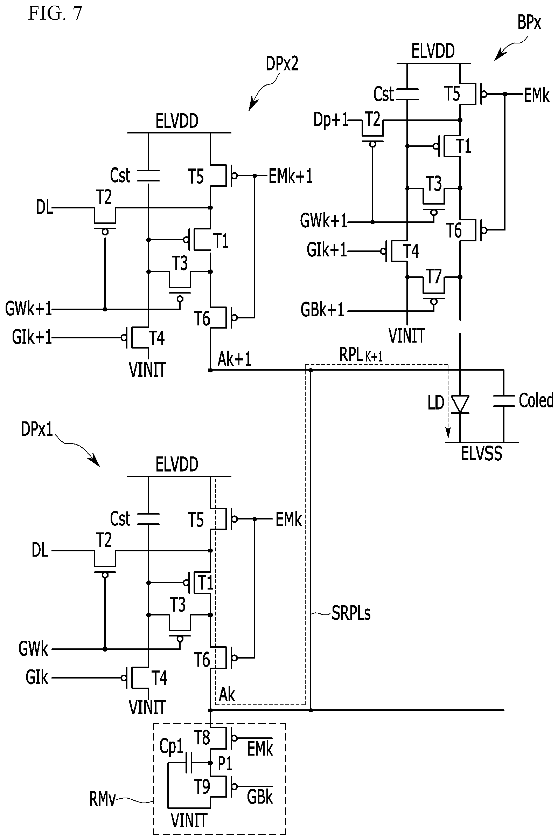

Hereinafter, a repairing method of a defective pixel according to another embodiment of the invention will be described with reference to FIG. 7.

FIG. 7 is a circuit diagram of a repair procedure for a defective pixel according to another embodiment of the invention.

The same configuration as the repairing method of the defective pixel according to the embodiment of FIGS. 5 and 6 designates the same reference numeral and description of the same configuration is omitted.

Referring to FIG. 7, for example, when a defective is generated in a pixel BPX connected to a scan line GWk+1 and a data line Dp+1, a line between the anode of the OLED LD of the defective pixel BPX and the switching transistor T6 is disconnected, and the anode of the OLED LD of the defective pixel BPX and the node Ak+1 are connected to each other through the repair line RPLk+1. In addition, the data signal supplied from the data line Dp+1 is transferred to the dummy signal line DL. Then, the OLED LD of the defective pixel BPX can normally emit light by the current transferred from the driving transistor T1 of the dummy pixel DPx1.

Further, a data signal corresponding to a black gray is applied to the first input and output terminal of the switching transistor T2 of the dummy pixel DPx2 through the dummy signal line DL and thus the current transferred from the transistor T1 of the dummy pixel DPx2 is about 0 A.

Since the repairing method of the defective pixel BPX by connecting the defective pixel BPX with the dummy pixel DPx1 and using the dummy pixel DPxl, the repair modulation circuit RMv, and the dummy pixel DPx2 is the same as that of the embodiment of the invention described with reference to FIGS. 5 and 6 described above, the method is omitted.

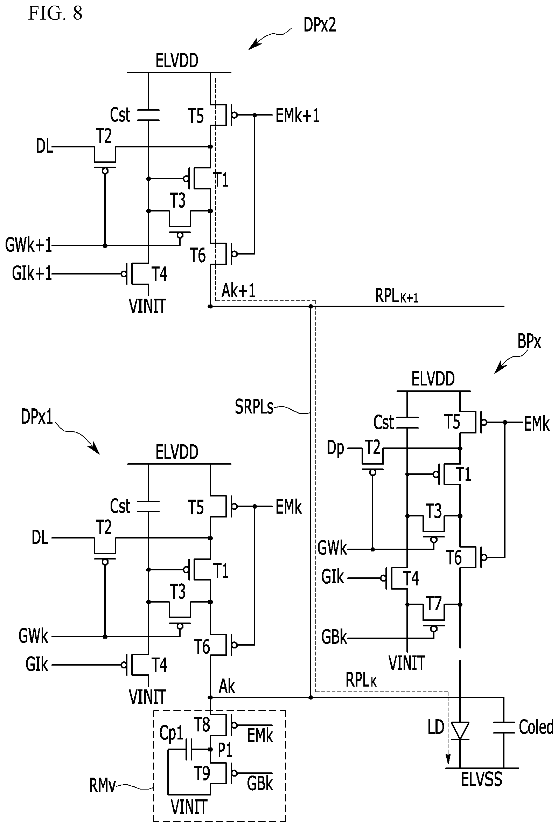

Hereinafter, a repairing method of a defective pixel according to yet another embodiment of the invention will be described with reference to FIG. 8.

FIG. 8 is a circuit diagram of a repair procedure for a defective pixel according to this embodiment.

The same configuration as the repairing method of the defective pixel according to the embodiment of the invention of FIGS. 5 and 6 designates the same reference numeral and description of the same configuration is omitted.

Referring to FIG. 8, for example, when a defective is generated in a pixel BPX connected to a scan line GWk and a data line Dp, a line between the anode of the OLED LD of the defective pixel BPX and the switching transistor T6 is disconnected, and the anode of the OLED LD of the defective pixel BPX and the node Ak are connected to each other through the repair line RPLk. In addition, the data signal supplied from the data line Dp is transferred to the dummy signal line DL. Then, the OLED LD of the defective pixel BPX can normally emit light by the current transferred from the driving transistor T1 of the dummy pixel DPx2.

Further, a data signal corresponding to a black gray is applied to the first input and output terminal of the switching transistor T2 of the dummy pixel DPx1 through the dummy signal line DL and thus the current transferred from the transistor T1 of the dummy pixel DPx1 is about 0 A.

Since the repairing method of the defective pixel BPX by connecting the defective pixel BPX with the dummy pixel DPx1 and using the dummy pixel DPxl, the repair modulation circuit RMv, and the dummy pixel DPx2 is the same as that of the embodiment of the invention described with reference to FIGS. 5 and 6 described above, the method is omitted.

Hereinafter, a repairing method of a defective pixel according to another embodiment of the invention will be described.

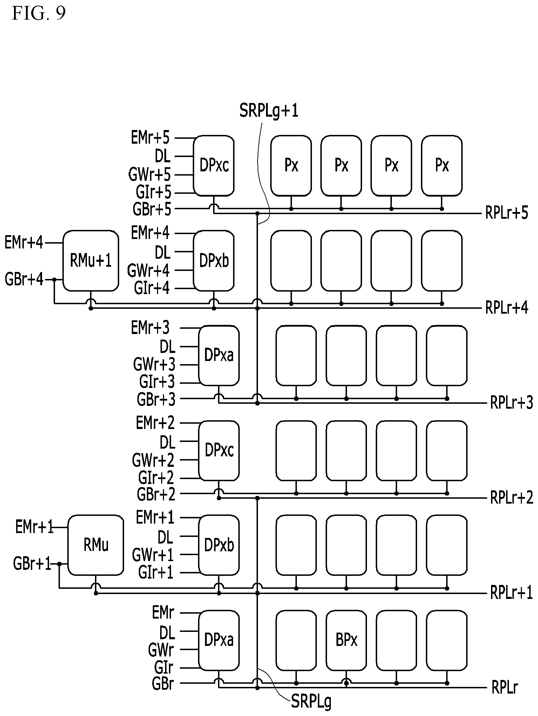

FIG. 9 is a block diagram illustrating a repair procedure according to another embodiment of the invention.

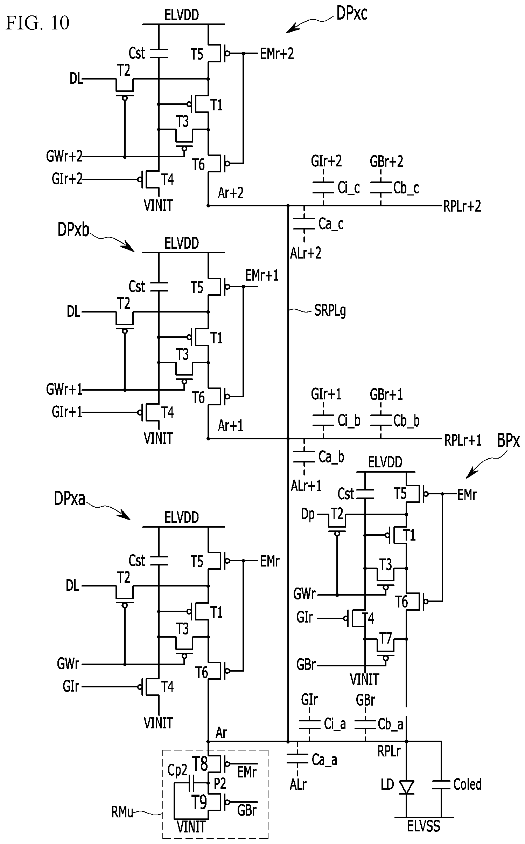

FIG. 10 is a circuit diagram of the defective pixel and dummy pixels of FIG. 9.

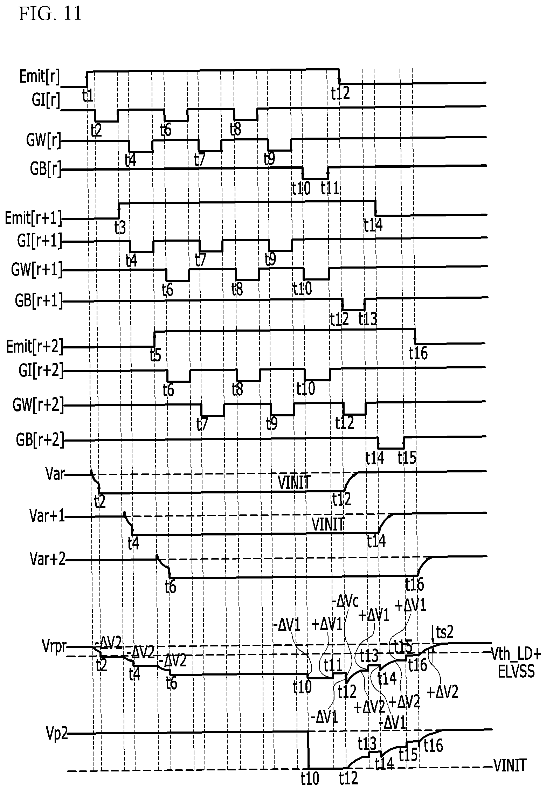

FIG. 11 is a signal timing of the defective pixel and dummy pixels of FIG. 10.

Referring to FIG. 9, a dummy pixel DPxa, a dummy pixel DPxb, and a dummy pixel DPxc are connected to a plurality of corresponding repair lines among a plurality of repair lines RPLr, RPLr+1, RPLr+2, RLr+3, RLr+4, and RLr+5, respectively. Each of a plurality of repair modulation circuits RMu and RMu+1 is connected to each of the plurality of dummy pixels DPxb.

Each of the dummy pixels DPxa, the dummy pixels DPxb, and the dummy pixels DPxc is connected to each of a plurality of sub repair lines SRPLg and SRPLg+1. Further, the dummy pixel DPxa connected to the repair line RPLr, the dummy pixel DPxb connected to the repair line RPLr+1, and the dummy pixel DPxc connected to the repair line RPLr+2 share the repair modulation circuit RMu. The dummy pixel DPxa connected to the repair line RPLr+3, the dummy pixel DPxb connected to the repair line RPLr+4, and the dummy pixel DPxc connected to the repair line RPLr+5 share the repair modulation circuit RMu+1.

The pixels PX and a defective pixel BPX are connected to second corresponding initialization lines among a plurality of second initialization lines GBr, GBr+1, GBr+2, GBr+3, GBr+4, and GBr+5, respectively.

Each of the dummy pixels DPxa, the dummy pixels DPxb, and the dummy pixels DPxc according to another embodiment of the invention can be a pixel circuit driving a red, blue, or green OLED LD.

The dummy pixel DPxa connected to the repair line RPLr is connected to the light emission scan line EMr, the dummy signal line DL, the scan line GWr, and the first initialization scan line GIr.

The repair modulation circuit RMu is connected to the repair line RPLr+1, the light emission scan line EMr+1, and the second initialization scan line GBr+1.

The dummy pixel DPxb connected to the repair line RPLr+1 is connected to the light emission scan line EMr+1, the dummy signal line DL, the scan line GWr+1, and the initialization scan line GIr+1.

The dummy pixel DPxc connected to the repair line RPLr+2 is connected to the light emission scan line EMr+2, the dummy signal line DL, the scan line GWr+2, and the initialization scan line GIr+2.

The dummy pixel DPxa connected to the repair line RPLr+3 is connected to the light emission scan line EMr+3, the dummy signal line DL, the scan line GWr+3, and the initialization scan line GIr+3.

The repair modulation circuit RMu+1 is connected to the repair line RPLr+4, the light emission scan line EMr+4, and the second initialization scan line GBr+4.

The dummy pixel DPxb connected to the repair line RPLr+4 is connected to the light emission scan line EMr+4, the dummy signal line DL, the scan line GWr+4, and the initialization scan line GIr+4.

The dummy pixel DPxc connected to the repair line RPLr+5 is connected to the repair line RPLr+5, the light emission scan line EMr+5, the dummy signal line DL, the scan line GWr+5, and the initialization scan line GIr+5.

Hereinafter, a repairing method of the defective pixel BPX by connecting the defective pixel BPX with the dummy pixel DPxb and using the dummy pixel DPxa, the repair modulation circuit RMu, the dummy pixel DPxb, and the dummy pixel DPxc will be described with reference to FIG. 10.

Referring to FIG. 10, the dummy pixel DPxa, the dummy pixel DPxb, and the dummy pixel DPxc include dummy pixel driving circuits.

The dummy pixel driving circuit of the dummy pixel DPxa includes the driving transistor T1, the capacitor Cst, and the switching transistors T2, T3, T4, T5, and T6.

The dummy pixel driving circuit of the dummy pixel DPxb includes the driving transistor T1, the capacitor Cst, and the switching transistors T2, T3, T4, T5, and T6.

The dummy pixel driving circuit of the dummy pixel DPxc includes the driving transistor T1, the capacitor Cst, and the switching transistors T2, T3, T4, T5, and T6.

The repair modulation circuit RMu includes switching transistors T8 and T9 and a capacitor Cp2.

The driving transistors T1, the capacitors Cst, and the switching transistors T2, T3, T4, T5, and T6 of the dummy pixel driving circuits of the dummy pixel DPxa, the dummy pixel DPxb, and the dummy pixel DPxc are connected to each other like the corresponding configuration of the driving transistor T1, the capacitor Cst, and the switching transistors T2, T3, T4, T5, and T6 of the dummy pixel DPx1 illustrated in FIG. 5.

Further, the switching transistors T8 and T9 and the capacitor Cp2 of the repair modulation circuit RMu are connected the same as the switching transistors T8 and T9 and the capacitor Cpl of the repair modulation circuit RMv of FIG. 5.

The control terminal of the switching transistor T4 of the dummy pixel DPxa is connected to the first initialization scan line GIr, and the second input and output terminal of the switching transistor T6 is connected to the node Ar.

The control terminal of the switching transistor T4 of the dummy pixel DPxb is connected to the first initialization scan line GIr+1, and the second input and output terminal of the switching transistor T6 is connected to the node Ar+1.

The control terminal of the switching transistor T4 of the dummy pixel DPxc is connected to the first initialization scan line GIr+2, and the second input and output terminal of the switching transistor T6 is connected to the node Ar+2.

The repair line RPLr is connected to the anode of the OLED LD of the defective pixel BPX, and the node Ar, the node Ar+1, and the node Ar+2 are connected to each other through the sub repair line SRPLg.

Referring to FIG. 10, for example, when a defective is generated in a pixel BPX connected to an r-th scan line GWr and a p-th data line Dp, a line between the anode of the OLED LD of the defective pixel BPX and the switching transistor T6 is disconnected, and the anode of the OLED LD of the defective pixel BPX and the node Ar are connected to each other through the repair line RPLr. In addition, the data signal supplied from the data line Dp is transferred to the dummy signal line DL. Then, the OLED LD of the defective pixel BPX can normally emit light by the current transferred from the driving transistor T1 of the dummy pixel DPxa.

Further, a data signal corresponding to a black gray is applied to the switching transistor T2 of the dummy pixel DPxb and the first input and output terminal of the switching transistor T2 of the dummy pixel DPxc through the dummy signal line DL and thus the current transferred from the driving transistor T1 of the dummy pixel DPxb and the driving transistor T1 of the dummy pixel DPxc is 0A.

In this case, a parasitic capacitor Ca_a can be formed by the repair line RPLr and the anode line ALr of normal pixels PX (see FIG. 9) of an r-th line (the same line as the defective pixel BPX). A parasitic capacitor Ci_a can be formed by the repair line RPLr and the first initialization scan line GIr connected to the control terminal of the transistor T4 of the defective pixel BPX. A parasitic capacitor Cb_a can be formed by the repair line RPLr and the second initialization scan line GBr connected to the control terminal of the transistor T9 of the repair modulation circuit RMu.

Further, a parasitic capacitor Ca_b can be formed by the repair line RPLr+1 and the anode line ALr+1 of normal pixels PX (see FIG. 9) of an r+1-th line. A parasitic capacitor Ci_b can be formed by the repair line RPLr+1 and the first initialization scan line GIr+1 connected to the control terminal of the transistor T4 of normal pixels PX (see FIG. 9) of the r+1-th line. A parasitic capacitor Cb_b can be formed by the repair line RPLr+1 and the second initialization scan line GBr+1 connected to the control terminal of the switching transistor T7 of normal pixels PX (see FIG. 9) of the r+1-th line.

Further, a parasitic capacitor Ca_c can be formed by the repair line RPLr+2 and the anode line ALr+2 of normal pixels PX (see FIG. 9) of an r+2-th line. A parasitic capacitor Ci_c can be formed by the repair line RPLk+2 and the first initialization scan line GIr+2 connected to the control terminal of the transistor T4 of normal pixels PX (see FIG. 9) of the r+2-th line. A parasitic capacitor Cb_c can be formed by the repair line RPLr+2 and the second initialization scan line GBr+2 connected to the control terminal of the switching transistor T7 of normal pixels PX (see FIG. 4) of the r+2-th line.

Referring to FIG. 11, at a time t1, when the light emission signal Emit[r] is converted from the low voltage Vgl to the high voltage Vgh, the switching transistors T5 and T6 of the defective pixel BPX are turned off. Then, a voltage charged in a parasitic capacitor Coled of the OLED LD of the defective pixel BPX is reduced and thus an anode voltage Var is reduced. In this case, the anode voltage Var is a representative anode voltage of the plurality of pixels PX (see FIG. 4) positioned in an r-th row.

Further, the switching transistors T5 and T6 of the dummy pixel DPxa and the switching transistor T8 of the repair modulation circuit RMu are turned off, and as a result, the voltage charged in a parasitic capacitor Coled of the OLED LD of the defective pixel BPX is reduced and thus a voltage Vrpr of the repair line RPLr is reduced.

At a time t2, the first initialization signal GI[r] is converted from the high voltage Vgh to the low voltage Vgl and thus a control terminal voltage of the driving transistor T1 of the dummy pixel DPxa is initialized with an initialization voltage VINIT. Accordingly, the voltage Vrpr of the repair line RPLr is reduced by the parasitic capacitor Ci_a formed by the first initialization scan line GIr. For example, the voltage Vrpr is reduced by ΔV2 voltage to be reduced up to a voltage corresponding to approximately ELVSS+Vth_LD.

Further, the anode voltage Var is initialized with the initialization voltage VINIT. Thereafter, until a time t12 when the light emission signal Emit[r] is converted from the high voltage Vgh to the low voltage Vgl, the anode voltage Var is maintained as the initialization voltage VINIT.

At a time t3, when the light emission signal Emit[r+1] is converted from the low voltage Vgl to the high voltage Vgh, the switching transistors T5 and T6 of the dummy pixel DPxb and the switching transistors T5 and T6 of all the pixels in the r+1-th row are turned off, and the voltage charged in the parasitic capacitor Coled of the OLED of all the pixels in the r+1-th row is reduced. As a result, the anode voltage Var+1 and the voltage Vrpr+1 of the repair line RPLr+1 are reduced.

At a time t4, the first initialization signal GI[r+1] is converted from the high voltage Vgh to the low voltage Vgl and thus a control terminal voltage of the driving transistor T1 of the dummy pixel DPxb is initialized with the initialization voltage VINIT. Accordingly, the voltage Vrpr+1 of the repair line RPLr+1 is also reduced by ΔV2 voltage by the parasitic capacitor Ci_b formed by the first initialization scan line GIr+1.

Further, the anode voltage Var+1 is initialized to the initialization voltage VINIT. Thereafter, until a time t14 when the light emission signal Emit[r+1] is converted from the high voltage Vgh to the low voltage Vgl, the anode voltage Var+1 is maintained as the initialization voltage VINIT.

In addition, the data signal supplied from the data line Dp is transferred to the dummy signal line DL.

At a time t5, when the light emission signal Emit[r+2] is converted from the low voltage Vgl to the high voltage Vgh, the switching transistors T5 and T6 of the dummy pixel DPxc and the switching transistors T5 and T6 of all pixels in the r+2-th row are turned off, and the voltage charged in the parasitic capacitor Coled of the OLED of all pixels in the r+2-th row is reduced. As a result, the anode voltage Var+2 and the voltage Vrpr+2 of the repair line RPLr+2 are reduced.

At a time t6, the first initialization signal GI[r+2] is converted from the high voltage Vgh to the low voltage Vgl and thus a control terminal voltage of the driving transistor T1 of the dummy pixel DPxc is initialized with the initialization voltage VINIT. Accordingly, the voltage Vrpr+2 of the repair line RPLr+2 is also reduced by ΔV2 voltage by the parasitic capacitor Ci_c formed by the first initialization scan line GIr+2.

Further, the anode voltage Var+2 is initialized with the initialization voltage VINIT. Thereafter, until a time tl6 when the light emission signal Emit[r+2] is converted from the high voltage Vgh to the low voltage Vgl, the anode voltage Var+2 is maintained as the initialization voltage VINIT.

Further, a data signal of a black gray is transferred to the dummy pixel DPxb through the dummy signal line DL.

At a time t7, a data signal of a black gray is transferred to the dummy pixel DPxc through the dummy signal line DL.

At the times t2, t6, and t8, the voltage of the initialization scan signal GI[r] is repeatedly converted from the high voltage Vgh to the low voltage Vgl, and at the times t4, t7, and t9, the voltage of the scan signal GW[r] is repeatedly converted from the high voltage Vgh to the low voltage Vgl.

At the times t4, t7, and t9, the voltage of the initialization scan signal GI[r+1] is repeatedly converted from the high voltage Vgh to the low voltage Vg, and at the times t6, t8, and t10, the voltage of the scan signal GW[r+1] is repeatedly converted from the high voltage Vgh to the low voltage Vgl.

At the times t6, t8, and t10, the voltage of the initialization scan signal Gi[r+1] is repeatedly converted from the low voltage Vgl to the high voltage Vgh, and at the times t7, t9, and t12, the voltage of the scan signal GW[r+1] is repeatedly converted from the low voltage Vgl to the high voltage Vgh.

When a black image or a white image is displayed and driven for a long time, a level of the voltage applied to the driving transistor T1 is continued to prevent a hysteresis phenomenon.

At a time t10, the second initialization signal GB[r] applied to the normal pixel PX (see FIG. 9) in the r-th row is converted from the high voltage Vgh to the low voltage Vgl. When the initialization signal GB[r] is reduced to the low voltage Vgl, the switching transistor T9 of the repair modulation circuit RMu is turned on and the capacitor Cp2 is initialized with the initialization voltage VINIT. In this case, the voltage Vrpr of the repair line RPLr can be reduced by ΔV1 voltage by the parasitic capacitor Cb_a formed by the second initialization scan line GBr. Further, the voltage Vp2 of the node P2 is reduced to the initialization voltage VINIT.

At a time t11, the second initialization signal GB[r] is increased to the high voltage Vgh and thus the voltage Vrpr of the repair line RPLr can be increased by ΔV1 voltage by the parasitic capacitor Cb_a.

At a time t12, the second initialization signal GB[r+1] applied to the normal pixel PX (see FIG. 9) in the r+1-th row is converted from the high voltage Vgh to the low voltage Vgl. In this case, the voltage Vrpr+1 of the repair line RPLr+1 can be reduced by ΔV1 voltage by the parasitic capacitor Cb_b formed by the second initialization scan line GBr+1.

Further, the light emission signal Emit[r] is converted to the lower voltage. Then, the driving current corresponding to the data signal supplied from the data line Dp to the dummy signal line DL is output from the driving transistor T1 of the dummy pixel DPxa to the repair line RPLr. A part of the current output from the driving transistor T1 of the dummy pixel DPxa is used to compensate for the voltage of the capacitor Cp2 initialized with the initialization voltage VINIT. Charges charged in the parasitic capacitors Ci_a, Cb_a, and Coled move to the capacitor Cp2 by charge sharing of the parasitic capacitors Ci_a, Cb_a, and Coled and the capacitor Cp2 and thus the voltage Vrpr of the repair line RPLr is reduced by ΔVc.

Further, even in the defective pixel BPX, the current is supplied to the driving transistor T1 to charge the parasitic capacitor Coled of the OLED LD, and thus the anode voltage Var of the OLED LD is increased. As a result, the voltage Vrpr of the repair line RPLr can be increased by ΔV2 voltage by the parasitic capacitor Ca_a. In this case, the voltage Vp2 of the node P2 is increased according to the voltage Vrpr of the repair line RPLr by the turned-on switching transistor T8.

At a time t13, the second initialization signal GB[r+1] is increased to the high voltage Vgh and thus the voltage Vrpr of the repair line RPLr can be increased by ΔV1 voltage by the parasitic capacitor Cb_b.

At a time tl4, the second initialization signal GB[r+2] applied to the normal pixel PX (see FIG. 9) in the R+2-th row is converted from the high voltage Vgh to the low voltage Vgl. In this case, the voltage Vrpr of the repair line RPLr can be reduced by ΔV1 voltage by the parasitic capacitor Cb_c formed by the second initialization scan line GBr+2.

Further, the light emission signal Emit[r+1] is converted to the lower voltage. As a result, the current is supplied through the driving transistor T1 of a dummy pixel DPx_b and thus the anode voltage Var+1 is increased. As a result, the voltage Vrpr+1 of the repair line RPLr+1 can be increased by ΔV2 voltage by the parasitic capacitor Ca_b. In this case, the voltage Vp2 of a node P2 is increased according to the voltage Vrpr of the repair line RPLr.

At a time t15, the second initialization signal GB[r+2] is increased to the high voltage Vgh and thus the voltage Vrpr of the repair line RPLr can be increased by ΔV1 voltage by the parasitic capacitor Cb_c.

At a time t16, the light emission signal Emit[r+2] is converted to the lower voltage. As a result, the current is supplied through the driving transistor T1 of a dummy pixel DPx_c and thus the anode voltage Var+2 is increased. As a result, the voltage Vrpr+2 of the repair line RPLr+2 can be increased by ΔV2 voltage by the parasitic capacitor Ca_c. In this case, the voltage Vp2 of a node P2 is increased according to the voltage Vrpr+2 of the repair line RPLr+2.

Meanwhile, after a time t2 when the charge sharing is completed, the parasitic capacitor Coled of the OLED LD of the defective pixel BPX and the parasitic capacitors Ca_a, Ca_b, and Ca_c of the repair line RPLr are charged by a part of the current output from the driving transistor T1 of the dummy pixel DPxa, DPxb and DPxc,DPxc, and thus the voltage Vrpr of the repair line RPLr is increased by the voltage corresponding to the low gray.

As such, according to the embodiment of the invention described with reference to FIGS. 9 to 11, a part of the current output from the driving transistor T1 is used to compensate for the voltage reduced by the charge sharing of the capacitor Cp2 and the parasitic capacitors Ci_a, Cb_a, and Coled, an effect by boosting due to the parasitic capacitors Ci_a, Cb_a, and Coled can be offset.

Further, a potential of the node P2 can be the same as a potential Vrpr of the repair line RPLr.

While the inventive technology has been described in connection with what are presently considered to be practical embodiments described, it is to be understood that the invention is not limited to the disclosed embodiments, but, on the contrary, is intended to cover various modifications and equivalent arrangements included within the scope of the appended claims.

**Claims**

1. A display device (10), comprising:

   a plurality of pixels (PX) arranged in an array with rows and columns of pixels (PX), each pixel (PX) comprising a pixel driving circuit and an organic light-emitting diode (OLED);
   a plurality of first dummy pixels (DPx1), wherein each dummy pixel (DPx) comprises a first dummy pixel driving circuit, and wherein each of the first dummy pixels (DPx1) is adjacent one of the even rows of pixels (PX);
   a plurality of second dummy pixels (DPx2), wherein each dummy pixel (DPx) comprises a second dummy pixel driving circuit and wherein each of the second dummy pixels (DPx2) is adjacent one of the odd rows of pixels (PX);
   a driving voltage line (ELVDD);
   a common voltage line (ELVSS);
   a voltage initialization line (VINIT);
   a plurality of first repair lines (RPLk), wherein each of the first repair lines (RPLk) extends in a direction of one of the even rows, and is electrically connected to the respective first dummy pixel driving circuit of the first dummy pixel (DPx1) adjacent the respective even row and to a respective repair modulation circuit (RMv) adjacent to the respective first dummy pixel driving circuit;
   a plurality of second repair lines (RPLk), wherein each of the second repair lines (RPLk) extends in a direction of one of the odd rows, and is electrically connected to the respective second dummy pixel driving circuit of the second dummy pixel (DPx2) adjacent the respective odd row;

a plurality of sub repair lines (SRPL), wherein each of the sub repair lines (SRPL) extends in the direction of the column of first (DPx1) and second (DPx2) dummy pixels, and is electrically connected to one of the first repair lines (RPLk) and to the one of the second repair lines (RPLk) extending in the direction of the even row, which is above the odd row, along which the one of the first repair lines (RPLk) extends;

a plurality of repair modulation circuits (RMv) electrically connected to the second dummy pixel driving circuits;

a plurality of first light emission scan lines (EMk), wherein each of the first light emission scan lines (EMk) is connected to one of the first dummy pixels (DPx1)
and to the corresponding one of the repair modulation circuits (RMv);

a plurality of second light emission scan lines (EMk+1) wherein each of the second light emission scan lines (EMk+1) is connected to one of the second dummy pixels (DPx2);

a dummy signal line (DL), wherein the dummy signal line (DL) is connected to each of the first dummy pixel (DPx1) and each of the second dummy pixels (DPx2);

a plurality of first scan lines, wherein each of the first scan lines is connected to one of the first dummy pixels (DPx1);

a plurality of second scan lines, wherein each of the second scan lines is connected to one of the second dummy pixels
(DPx2);

a plurality of first initialization scan lines (Glk), wherein each of the first initialization scan lines is connected to one of the first dummy pixels (DPx1);

a plurality of second initialization scan lines (Glk+1), wherein each of the second initialization scan lines is connected to one of the second dummy pixels (DPx2);

a plurality of third initialization scan lines (Gbk), wherein each of the second initialization scan lines is connected to one of the repair modulation circuits (RMv) and to the corresponding one of the even rows of pixels (PX); and

a plurality of fourth initialization scan lines, wherein each of the second initialization scan lines is connected to one of the repair modulation signals and to the corresponding one of the odd rows of pixels;

a dummy signal line (DL) extending in a column direction, wherein the dummy signal line is connected to each of the first and second dummy pixel circuits;

a plurality of data lines, wherein each of the data lines is connected to the pixels in one column;

wherein the first dummy pixel driving circuit is configured to output a driving current corresponding to a data voltage of a selected pixel (PX) of the OLED display device (10) to the repair line (RPLk), when the selected pixel (PX) becomes defective, based on a first light emission control signal,

wherein each pixel driving circuit comprises:

a pixel driving transistor (T1);
a first pixel switching transistor (T2);
a second pixel switching transistor (T3),
a third pixel switching transistor (T4);
a fourth pixel switching transistor (T5);
a fifth pixel switching transistor (T6);
a sixth pixel switching transistor (T7); and
a pixel capacitor (Cst), the pixel capacitor having a first terminal and a second terminal, the first terminal being connected to the driving voltage line;

wherein each transistor has a respective input, output and control terminal, and

wherein the control terminal of the pixel driving transistor is connected to the second terminal of the pixel capacitor, the input of the second pixel switching transistor and the input of the third pixel switching transistor,

wherein the control terminals of the first and second pixel switching transistors are connected to one of the plurality of first scan lines or one of the plurality of second scan lines,

wherein the control terminal of the third pixel switching transistor is connected to one of the plurality of first scan initialization lines or one of the plurality of second scan initialization lines,

wherein the control terminals of the fourth and fifth pixel switching transistors are connected to one of the plurality of first emission lines or one of the plurality of second emission lines,

wherein the control terminal of the sixth pixel switching transistor is connected to the one of the plurality of third scan initialization lines or one of the plurality of fourth scan initialization lines.

wherein the input of the pixel driving transistor is connected to output of the first pixel switching transistor and the output of the fourth pixel switching transistor,

wherein the output of the pixel driving transistor is connected to the output of the second pixel switching transistor and to the input of the fifth pixel switching transistor,

wherein the input of the first pixel switching transistor is connected to one of the plurality of data lines,

wherein the input of the fourth pixel switching transistor is connected to the driving voltage line,

wherein the output of the third pixel switching transistor is connected to the initialization voltage line and the input of the sixth pixel switching transistor,

wherein the outputs of the fifth and sixth pixel switching transistors are connected to the anode of the OLED; and wherein a cathode of the OLED is connected to the common voltage line, and

wherein each first dummy pixel driving circuit comprises:

a first dummy pixel driving transistor (T1);
a first first dummy pixel switching transistor (T2);
a second first dummy pixel switching transistor (T3),
a third first dummy pixel switching transistor (T4);
a fourth first dummy pixel switching transistor (T5);
a fifth first dummy pixel switching transistor (T6); and
a first dummy capacitor (Cst), the first dummy capacitor having a first terminal and a second terminal, the first terminal being connected to the driving voltage line;

wherein each first dummy pixel transistor has a respective input, output and control terminal, and

wherein the control terminal of the first dummy pixel driving transistor is connected to the second terminal of the first dummy capacitor, the input of the second first dummy pixel switching transistor and the input of the third first dummy pixel switching transistor,

wherein the control terminals of the first and second first dummy pixel switching transistors are connected to one of the plurality of first scan lines,

wherein the control terminal of the third first dummy pixel switching transistor is connected to one of the plurality of first scan initialization lines,

wherein the control terminals of the fourth and fifth first dummy pixel transistors are connected to one of the plurality of first emission lines,

wherein the input of the first dummy pixel driving transistor is connected to output of the first first dummy pixel switching transistor and the output of the fourth first dummy pixel switching transistor,

wherein the output of the first dummy pixel driving transistor is connected to the output of the second first dummy pixel switching transistor and to the input of the fifth first dummy pixel switching transistor,

wherein the input of the first first dummy pixel switching transistor is connected to the dummy signal line,

wherein the input of the fourth first dummy pixel switching transistor is connected to the driving voltage line,

wherein the output of the third first dummy pixel switching transistor is connected to the voltage initialization line,

wherein the output of the fifth first dummy pixel switching transistor are connected to one of the plurality of second repair lines, and

wherein each second dummy pixel driving circuit comprises:

a second dummy pixel driving transistor (T1);
a first second dummy pixel switching transistor (T2);
a second second dummy pixel switching transistor (T3),
a third second dummy pixel switching transistor (T4);
a fourth second dummy pixel switching transistor (T5);
a fifth second dummy pixel switching transistor (T6); and
a second dummy pixel capacitor (Cst), the second dummy pixel capacitor having a first terminal and a second terminal, the first terminal being connected to the driving voltage line,

wherein each second dummy pixel transistor has a respective input, output and control terminal, and

wherein the control terminal of the second dummy pixel driving transistor is connected to the second terminal of the second dummy capacitor, the input of the second second dummy pixel switching transistor and the input of the third second dummy pixel switching transistor,

wherein the control terminals of the first and second second dummy pixel switching transistors are connected to one of the plurality of second scan lines,

wherein the control terminal of the third second dummy pixel switching transistor is connected to one of the plurality of second scan initialization lines,

wherein the control terminals of the fourth and fifth second dummy pixel transistors are connected to one of the plurality of first emission lines,

wherein the input of the second dummy pixel driving transistor is connected to output of the first second dummy pixel switching transistor and the output of the fourth second dummy pixel switching transistor,

wherein the output of the second dummy pixel driving transistor is connected to the output of the second second dummy pixel switching transistor and to the input of the fifth second dummy pixel switching transistor,

wherein the input of the first second dummy pixel switching transistor is connected to the dummy signal line,

wherein the input of the fourth second dummy pixel switching transistor is connected to the driving voltage line,

wherein the output of the third second dummy pixel switching transistor is connected to the voltage initialization line, and

wherein the output of the fifth second dummy pixel switching transistor are connected to one of the plurality of second repair lines,

wherein each of the repair modulation circuits (RMv) is connected to one of the first repair lines (RPLk), wherein each repair modulation circuit (RMv) comprises:

   a repair modulation circuit capacitor, comprising a first terminal and a second terminal;
   a repair modulation circuit switching transistor (T8);
   an initialization transistor (T9),

wherein each transistor comprises an input, an output and a control terminal,

wherein the input of the repair modulation circuit switching transistor is connected to one of the plurality of first repair lines,

wherein the control terminal of the repair modulation circuit switching transistor is connected to one of the plurality of first emission lines,

wherein the output of the repair modulation circuit switching transistor is connected to the second terminal of the repair modulation circuit capacitor and to the input of the initialization transistor;

wherein the control terminal of the initialization transistor is connected to one of the plurality of third scan initialization lines, and

wherein the first terminal of the repair modulation circuit capacitor and the output of the initialization transistor are connected to the voltage initialization line,

wherein the repair modulation circuit switching transistor is configured to be turned on or off according to a signal received from the first emission control line, and

wherein the repair modulation circuits (RMv) are configured to:

   initialize the capacitor before the driving current is output from the first dummy pixel driving circuit;
   charge the capacitor of the repair modulation circuit (RMv) with the driving current when the driving current is output from the first dummy pixel driving circuit, and

   share the charged current with a parasitic capacitance of the repair line (RPLk).

2. A display device (10) according to claim 1, wherein the second dummy pixel driving circuit is configured to apply a driving current corresponding to a first data voltage to the repair line (RPLk) based on a second light emission control signal, and wherein the first data voltage includes a black gray data voltage, and wherein the driving current is 0A.

3. A display device (10) according to claim 1, wherein the first dummy pixel driving circuit is configured to provide the driving current to the repair line (RPLk) after the initialization transistor (T8, T9) is turned on.

4. A method of repairing a display device (10) according to any preceding claim the method comprising:

   in the defective pixel (BPX), disconnecting an OLED of the defective pixel (BPX) from a pixel
   driving circuit of the defective pixel (BPX);

      electrically connecting a repair line (RPLk) to an organic light-emitting diode (OLED) of a defective pixel (BPX) in the display device (10), wherein the repair modulation circuit (RMv) includes a capacitor;
      initializing the capacitor of a respective repair modulation circuit (RMv);
      providing a driving current corresponding to a data voltage of the defective pixel (BPX) to the repair line (RPLk) in the first dummy pixel driving circuit;
      charging the capacitor with the driving current when the driving current is output from the first dummy pixel driving circuit; and

sharing the charged current of the capacitor with a parasitic capacitance of the charged capacitor and the repair line (RPLk).

5. A method according to claim 4, further comprising:

electrically connecting the first dummy pixel driving circuit, the second dummy pixel driving circuit, and the repair modulation circuit (RMv) to a sub repair line (SRPL); and
sharing the repair modulation circuit (RMv) between the first and second dummy pixel driving circuits.

6. A method according to claim 5, wherein the method further comprises applying a driving current corresponding to a first data voltage to the repair line (RPLk) based on a second light emission control signal, and wherein the first data voltage includes a black gray data voltage.

7. A method according to claim 6, wherein the initializing of the capacitor includes changing the voltage of the first initialization signal from a first level to a second level so as to turn on the initialization transistor.

8. A method according to claim 7, wherein the providing of the driving current to the repair line (RPLk) includes providing the driving current to the repair line (RPLk) via the first dummy pixel driving circuit after the initialization transistor is turned on.

**Patentansprüche**

1. Anzeigevorrichtung (10), umfassend:

eine Mehrzahl von Pixeln (PX), die in einer Anordnung mit Reihen und Spalten von Pixeln (PX) angeordnet sind, wobei jedes Pixel eine Pixeltreiberschaltung und eine organische lichtemittierende Diode (OLED) umfasst;
eine Mehrzahl von ersten Dummypixeln (DPx1), wobei jedes Dummypixel (DPx) eine erste Dummypixeltreiberschaltung umfasst und wobei jedes der ersten Dummypixel (DPx1) einer der geraden Reihen von Pixeln (PX) benachbart ist;
eine Mehrzahl von zweiten Dummpixeln (DPx2), wobei jedes Dummypixel (DPx) eine zweite Dummypixeltreiberschaltung umfasst und wobei jedes der zweiten Dummypixel (DPx2) einer der ungeraden Reihen von Pixeln (PX) benachbart ist;
eine Treiberspannungsleitung (ELVDD);
eine gemeinsame Spannungsleitung (ELVSS);
eine Spannungsinitialisierungsleitung (VINIT);
eine Mehrzahl von ersten Reparaturleitungen (RPLk), wobei jede der ersten Reparaturleitungen (RPLk) sich in einer Richtung einer der geraden Reihen erstreckt und mit der jeweiligen ersten Dummypixeltreiberschaltung des der jeweiligen geraden Reihe benachbarten ersten Dummypixels (DPx1) und mit einer jeweiligen der jeweiligen ersten Dummypixeltreiberschaltung benachbarten Reparaturmodulationsschaltung (RMv) elektrisch verbunden ist;
eine Mehrzahl von zweiten Reparaturleitungen (RPLk), wobei jede der zweiten Reparaturleitungen (RPLk) sich in einer Richtung einer der ungeraden Reihen erstreckt und mit der jeweiligen zweiten Dummypixeltreiberschaltung des der jeweiligen ungeraden Reihe benachbarten zweiten Dummypixels (DPx2) elektrisch verbunden ist;
eine Mehrzahl von untergeordneten Reparaturleitungen (SRPL), wobei jede der untergeordneten Reparaturleitungen (SRPL) sich in einer Richtung der Spalte von ersten (DPx1) und zweiten (DPx2) Dummypixeln erstreckt und mit einer der ersten Reparaturleitungen (RPLk) und mit der einen der sich in die Richtung der geraden Reihe, die über der ungeraden Reihe, entlang welcher sich die eine der ersten Reparaturleitungen (RPLK) erstreckt, liegt, erstreckenden zweiten Reparaturleitungen (RPLK) elektrisch verbunden ist;
eine Mehrzahl von Reparaturmodulationsschaltungen (RMv), die mit den zweiten Dummypixeltreiberschaltungen elektrisch verbunden sind;
eine Mehrzahl von ersten Lichtemissionsabtastleitungen (EMk), wobei jede der ersten Lichtemissionsabtastleitungen (EMk) mit einem der ersten Dummypixel (DPx1) und mit der entsprechenden einen der Reparaturmodulationsschaltungen (RMv) verbunden ist;
eine Mehrzahl von zweiten Lichtemissionsabtastleitungen (Emk+1), wobei jede der zweiten Lichtemissionsabtastleitungen (Emk+1) mit einem der zweiten Dummypixel (DPx2) verbunden ist;
eine Dummysignalleitung (DL), wobei die Dummysignalleitung (DL) mit jedem der ersten Dummypixel (DPx1) und jedem der zweiten Dummypixel (DPx2) verbunden ist;

eine Mehrzahl von ersten Abtastleitungen, wobei jede der ersten Abtastleitungen mit einem der ersten Dummypixel (DPx1) verbunden ist;

eine Mehrzahl von zweiten Abtastleitungen, wobei jede der zweiten Abtastleitungen mit einem der zweiten Dummypixel (DPx2) verbunden ist;

eine Mehrzahl von ersten Initialisierungsabtastleitungen (Glk), wobei jede der ersten Initialisierungsabtastleitungen mit einem der ersten Dummypixel (DPx1) verbunden ist;

eine Mehrzahl von zweiten Initialisierungsabtastleitungen (Glk+1), wobei jede der zweiten Initialisierungsabtastleitungen mit einem der zweiten Dummypixel (DPx2) verbunden ist;

eine Mehrzahl von dritten Initialisierungsabtastleitungen (Gbk), wobei jede der zweiten Initialisierungsabtastleitungen mit einer der Reparaturmodulationsschaltungen (RMv) und mit der entsprechenden einen der geraden Reihen von Pixeln (PX) verbunden ist; und

eine Mehrzahl von vierten Initialisierungsabtastleitungen, wobei jede der zweiten Initialisierungsabtastleitungen mit einem der Reparaturmodulationssignale und mit der entsprechenden einen der ungeraden Reihen von Pixeln verbunden ist;

eine Dummysignalleitung (DL), die sich in einer Spaltenrichtung erstreckt, wobei die Dummysignalleitung mit jeder der ersten und zweiten Dummypixelschaltungen verbunden ist;

eine Mehrzahl von Datenleitungen, wobei jede der Datenleitungen mit den Pixeln in einer Spalte verbunden ist;

wobei die erste Dummypixeltreiberschaltung dazu ausgestaltet ist, ausgehend von einem ersten Lichtemissionssteuersignal (PX) einen Treiberstrom, der einer Datenspannung eines ausgewählten Pixels (PX) der OLED-Anzeigevorrichtung (10) entspricht, an die Reparaturleitung (RPLk) auszugeben, wenn das ausgewählte Pixel schadhaft wird,

wobei jede Pixeltreiberschaltung Folgendes umfasst:

einen Pixeltreibertransistor (T1);
einen ersten Pixelschalttransistor (T2);
einen zweiten Pixelschalttransistor (T3);
einen dritten Pixelschalttransistor (T4);
einen vierten Pixelschalttransistor (T5);
einen fünften Pixelschalttransistor (T6);
einen sechsten Pixelschalttransistor (T7); und
einen Pixelkondensator (Cst), wobei der Pixelkondensator einen ersten Anschluss und einen zweiten Anschluss aufweist, wobei der erste Anschluss mit der Treiberspannungsleitung verbunden ist;

wobei jeder Transistor einen jeweiligen Eingang, Ausgang und Steuerungsanschluss aufweist, und

wobei der Steuerungsanschluss des Pixeltreibertransistors mit dem zweiten Anschluss des Pixelkondensators, dem Eingang des zweiten Pixelschalttransistors und dem Eingang des dritten Pixelschalttransistors verbunden ist,

wobei die Steuerungsanschlüsse des ersten und zweiten Pixelschalttransistors mit einer aus der Mehrzahl von ersten Abtastleitungen oder einer aus der Mehrzahl von zweiten Abtastleitungen verbunden sind,

wobei der Steuerungsanschluss des dritten Pixelschalttransistors mit einer aus der Mehrzahl von ersten Abtastinitialisierungsleitungen oder einer aus der Mehrzahl von zweiten Abtastinitialisierungsleitungen verbunden ist,

wobei die Steuerungsanschlüsse des vierten und fünften Pixelschalttransistors mit einer aus der Mehrzahl von ersten Emissionsleitungen oder einer aus der Mehrzahl von zweiten Emissionsleitungen verbunden sind,

wobei der Steuerungsanschluss des sechsten Pixelschalttransistors mit einer aus der Mehrzahl von dritten Abtastinitialisierungsleitungen oder einer aus der Mehrzahl von vierten Abtastinitialisierungsleitungen verbunden ist,

wobei der Eingang des Pixeltreibertransistors mit dem Ausgang des ersten Pixelschalttransistors und dem Ausgang des vierten Pixelschalttransistors verbunden ist,

wobei der Ausgang des Pixeltreibertransistors mit dem Ausgang des zweiten Pixelschalttransistors und mit dem Eingang des fünften Pixelschalttransistors verbunden ist,

wobei der Eingang des ersten Pixelschalttransistors mit einer aus der Mehrzahl von Datenleitungen verbunden ist,

wobei der Eingang des vierten Pixelschalttransistors mit der Treiberspannungsleitung verbunden ist,

wobei der Ausgang des dritten Pixelschalttransistors mit dem Initialisierungsspannungsleitung und dem Eingang des sechsten Pixelschalttransistors verbunden ist,

wobei die Ausgänge des fünften und sechsten Pixelschalttransistors mit der Anode der OLED verbunden sind; und wobei eine Kathode der OLED mit der gemeinsamen Spannungsleitung verbunden ist und

wobei jede erste Dummypixeltreiberschaltung Folgendes umfasst:

einen ersten Dummypixeltreibertransistor (T1);
einen ersten ersten Dummypixelschalttransistor (T2);
einen zweiten ersten Dummypixelschalttransistor (T3);
einen dritten ersten Dummypixelschalttransistor (T4);
einen vierten ersten Dummypixelschalttransistor (T5);
einen fünften ersten Dummypixelschalttransistor (T6); und
einen ersten Dummykondensator (Cst), wobei der erste Dummykondensator einen ersten Anschluss und einen zweiten Anschluss aufweist, wobei der erste Anschluss mit der Treiberspannungsleitung verbunden ist;

wobei jeder erste Dummypixeltransistor jeweils einen Eingang, Ausgang und Steuerungsanschluss aufweist und wobei der Steuerungsanschluss des ersten Dummypixeltreibertransistors mit dem zweiten Anschluss des ersten Dummykondensators, dem Eingang des zweiten ersten Dummypixelschalttransistors und dem Eingang des dritten ersten Dummypixelschalttransistors verbunden ist,
wobei die Steuerungsanschlüsse des ersten und zweiten ersten Dummypixelschalttransistors mit einer aus der Mehrzahl von ersten Abtastleitungen verbunden sind,
wobei der Steuerungsanschluss des dritten ersten Pixelschalttransistors mit einer aus der Mehrzahl von ersten Abtastinitialisierungsleitungen verbunden ist,
wobei die Steuerungsanschlüsse des vierten und fünften ersten Dummypixeltransistors mit einer aus der Mehrzahl von ersten Emissionsleitungen verbunden sind,
wobei der Eingang des ersten Dummypixeltreibertransistors mit dem Ausgang des ersten ersten Dummypixelschalttransistors und dem Ausgang des vierten ersten Dummypixelschalttransistors verbunden ist,
wobei der Ausgang des ersten Dummypixeltreibertransistors mit dem Ausgang des zweiten ersten Dummypixelschalttransistors und mit dem Eingang des fünften ersten Dummypixelschalttransistors verbunden ist,
wobei der Eingang des ersten ersten Dummypixelschalttransistors mit der Dummysignalleitung verbunden ist,
wobei der Eingang des vierten ersten Dummypixelschalttransistors mit der Treiberspannungsleitung verbunden ist,
wobei der Ausgang des dritten ersten Dummypixelschalttransistors mit der Spannungsinitialisierungsleitung verbunden ist,
wobei der Ausgang des fünften ersten Dummypixelschalttransistors mit einer aus der Mehrzahl von zweiten Reparaturleitungen verbunden ist und
wobei jede zweite Dummypixeltreiberschaltung Folgendes umfasst:

einen zweiten Dummypixeltreibertransistor (T1);
einen ersten zweiten Dummypixelschalttransistor (T2);
einen zweiten zweiten Dummypixelschalttransistor (T3),
einen dritten zweiten Dummypixelschalttransistor (T4);
einen vierten zweiten Dummypixelschalttransistor (T5);
einen fünften zweiten Dummypixelschalttransistor (T6); und
einen zweiten Dummypixelkondensator (Cst), wobei der zweite Dummypixelkondensator einen ersten Anschluss und einen zweiten Anschluss aufweist, wobei der erste Anschluss mit der Treiberspannungsleitung verbunden ist,

wobei jeder zweite Dummypixeltransistor jeweils einen Eingang, Ausgang und Steuerungsanschluss aufweist und
wobei der Steuerungsanschluss des zweiten Dummypixeltreibertransistors mit dem zweiten Anschluss des zweiten Dummykondensators, dem Eingang des zweiten zweiten Dummypixelschalttransistors und dem Eingang des dritten zweiten Dummypixelschalttransistors verbunden ist,
wobei die Steuerungsanschlüsse des ersten und zweiten zweiten Dummypixelschalttransistors mit einer aus der Mehrzahl von zweiten Abtastleitungen verbunden sind,
wobei der Steuerungsanschluss des dritten zweiten Dummypixelschalttransistors mit einer aus der Mehrzahl von zweiten Abtastinitialisierungsleitungen verbunden ist,
wobei die Steuerungsanschlüsse des vierten und fünften zweiten Dummypixeltransistors mit einer aus der Mehrzahl von ersten Emissionsleitungen verbunden sind,
wobei der Eingang des zweiten Dummypixeltreibertransistors mit dem Ausgang des ersten zweiten Dummypixelschalttransistors und dem Ausgang des vierten zweiten Dummypixelschalttransistors verbunden ist,

wobei der Ausgang des zweiten Dummypixeltreibertransistors mit dem Ausgang des zweiten zweiten Dummypixelschalttransistors und mit dem Eingang des fünften zweiten Dummypixelschalttransistors verbunden ist,

wobei der Eingang des ersten zweiten Dummypixelschalttransistors mit der Dummysignalleitung verbunden ist,

wobei der Eingang des vierten zweiten Dummypixelschalttransistors mit der Treiberspannungsleitung verbunden ist,

wobei der Ausgang des dritten zweiten Dummypixelschalttransistors mit der Spannungsinitialisierungsleitung verbunden ist, und

wobei der Ausgang des fünften zweiten Dummypixelschalttransistors mit einer aus der Mehrzahl von zweiten Reparaturleitungen verbunden ist,

wobei jede der Reparaturmodulationsschaltungen (RMv) mit einer der ersten Reparaturleitungen (RPLk) verbunden ist, wobei jede Reparaturmodulationsschaltung (RMv) Folgendes umfasst:

einen Reparaturmodulationsschaltungskondensator, der einen ersten Anschluss und einen zweiten Anschluss umfasst;

einen Reparaturmodulationsschaltungsschalttransistor (T8);

einen Initialisierungstransistor (T9),

wobei jeder Transistor einen Eingang, einen Ausgang und einen Steuerungsanschluss umfasst,

wobei der Eingang des Reparaturmodulationsschaltungsschalttransistors mit einer aus der Mehrzahl von ersten Reparaturleitungen verbunden ist,

wobei der Steuerungsanschluss des Reparaturmodulationsschaltungsschalttransistors mit einer aus der Mehrzahl von ersten Emissionsleitungen verbunden ist,

wobei der Ausgang des Reparaturmodulationsschaltungsschalttransistors mit dem zweiten Abschluss des Reparaturmodulationsschaltungskondensators und mit dem Eingang des Initialisierungstransistors verbunden ist;

wobei der Steuerungsanschluss des Initialisierungstransistors mit einer aus der Mehrzahl von dritten Abtastinitialisierungsleitungen verbunden ist und

wobei der erste Anschluss des Reparaturmodulationsschaltungskondensators und der Ausgang des Initialisierungstransistors mit der Spannungsinitialisierungsleitung verbunden sind,

wobei der Reparaturmodulationsschaltungsschalttransistor dazu ausgestaltet ist, an- oder ausgeschaltet zu werden gemäß eines Signals, das von der ersten Emissionssteuerungsleitung erhalten wird, und

wobei die Reparaturmodulationsschaltungen (RMv) dazu ausgestaltet sind:

den Kondensator zu initialisieren, bevor der Treiberstrom aus der ersten Dummypixeltreiberschaltung ausgegeben wird;

den Kondensator der Reparaturmodulationsschaltung (RMv) mit dem Treiberstrom zu laden, wenn der Treiberstrom aus der ersten Dummypixeltreiberschaltung ausgegeben wird, und

den geladenen Strom mit einer Streukapazität der Reparaturleitung (RPLk) zu teilen.

2. Anzeigevorrichtung (10) nach Anspruch 1, wobei die zweite Dummypixeltreiberschaltung dazu ausgestaltet ist, ausgehend von einem zweiten Lichtemissionssteuerungssignal einen Treiberstrom, der einer ersten Datenspannung entspricht, an die Reparaturleitung (RPLk) anzulegen, , und wobei die erste Datenspannung eine Schwarz-Grau-Datenspannung umfasst und wobei die Treiberspannung 0 A beträgt.

3. Anzeigevorrichtung (10) nach Anspruch 1, wobei die erste Dummypixeltreiberschaltung dazu ausgestaltet ist, der Reparaturleitung (RPLk) den Treiberstrom bereitzustellen, nachdem der Initialisierungstransistor (T8, T9) angeschaltet wird.

4. Verfahren zum Reparieren einer Anzeigevorrichtung (10) nach einem vorangehenden Anspruch, wobei das Verfahren Folgendes umfasst:

in dem schadhaften Pixel (BPX), Trennen einer OLED des schadhaften Pixels (BPX) von einer Pixeltreiberschaltung des schadhaften Pixels (BPX);

elektrisches Verbinden einer Reparaturleitung (RPLk) mit einer organischen lichtemittierenden Diode (OLED) eines schadhaften Pixels (BPX) in der Anzeigevorrichtung (10), wobei die Reparaturmodulationsschaltung (RMv) einen Kondensator umfasst;

Initialisieren des Kondensators einer jeweiligen Reparaturmodulationsschaltung (RMv);

Bereitstellen eines Treiberstroms, der einer Datenspannung des schadhaften Pixels (BPX) entspricht, an die Reparaturleitung (RPLk) in der ersten Dummypixeltreiberschaltung;

Laden des Kondensators mit dem Treiberstrom, wenn der Treiberstrom aus der ersten Dummypixeltreiberschaltung ausgegeben wird; und

Teilen des geladenen Stroms des Kondensators mit einer Streukapazität des geladenen Kondensators und der Reparaturleitung (RPLk).

5. Verfahren nach Anspruch 4, ferner umfassend:

elektrisches Verbinden der ersten Dummypixeltreiberschaltung, der zweiten Dummypixeltreiberschaltung und der Reparaturmodulationsschaltung (RMv) mit einer untergeordneten Reparaturleitung (SRPL); und

Teilen der Reparaturmodulationsschaltung (RMv) zwischen der ersten und zweiten Dummypixeltreiberschaltung.

6. Verfahren nach Anspruch 5, wobei das Verfahren ferner ein Anlegen eines Treiberstroms, der einer ersten Datenspannung entspricht, an die Reparaturleitung (RPLk) ausgehend von einem zweiten Lichtemissionssteuerungssignal umfasst, und wobei die erste Datenspannung eine Schwarz-Grau-Datenspannung umfasst.

7. Verfahren nach Anspruch 6, wobei das Initialisieren des Kondensators ein Ändern der Spannung des ersten Initialisierungssignals von einem ersten Niveau auf ein zweites Niveau umfasst, um den Initialisierungtransistor einzuschalten.

8. Verfahren nach Anspruch 7, wobei das Bereitstellen des Treiberstroms an die Reparaturleitung (RPLk) ein Bereitstellen des Treiberstroms an die Reparaturleitung (RPLk) über die erste Dummypixeltreiberschaltung umfasst, nachdem der Initialisierungstransistor angeschaltet wird.

**Revendications**

1. Dispositif d'affichage (10), comprenant :

une pluralité de pixels (PX) agencés en un réseau ayant des rangées et des colonnes de pixels (PX), chaque pixel (PX) comprenant un circuit d'attaque de pixel et une diode électroluminescente organique (OLED) ;

une pluralité de premiers pixels factices (DPx1), où chaque pixel factice (DPx) comprend un premier circuit d'attaque de pixel factice, et où chacun des premiers pixels factices (DPx1) est adjacent à l'une des rangées paires de pixels (PX) ;

une pluralité de seconds pixels factices (DPx2), où chaque pixel factice (DPx) comprend un second circuit d'attaque de pixel factice et où chacun des seconds pixels factices (DPx2) est adjacent à l'une des rangées impaires de pixels (PX) ;

une ligne de tension d'attaque (ELVDD) ;

une ligne de tension commune (ELVSS) ;

une ligne d'initialisation de tension (VINIT) ;

une pluralité de premières lignes de réparation (RPLk), où chacune des premières lignes de réparation (RPLk) s'étend dans une direction de l'une des rangées paires, et est électriquement connectée au premier circuit d'attaque de pixel factice respectif du premier pixel factice (DPx1) adjacent à la rangée paire respective et à un circuit de modulation de réparation respectif (RMv) adjacent au premier circuit d'attaque de pixel factice respectif ;

une pluralité de secondes lignes de réparation (RPLk), où chacune des secondes lignes de réparation (RPLk) s'étend dans une direction de l'une des rangées impaires, et est électriquement connectée au second circuit d'attaque de pixel factice respectif du second pixel factice (DPx2) adjacent à la rangée impaire respective ;

une pluralité de sous-lignes de réparation (SRPL), où chacune des sous-lignes de réparation (SRPL) s'étend dans la direction de la colonne des premier (DPx1) et second (DPx2) pixels factices, et est électriquement connectée à l'une des premières lignes de réparations (RPLk) et à l'une des secondes lignes de réparation (RPLk) s'étendant dans la direction de la rangée paire, qui est au-dessus de la rangée impaire, le long de laquelle ladite une des premières lignes de réparation (RPLk) s'étend ;

une pluralité de circuits de modulation de réparation (RMv) électriquement connectés aux seconds circuits d'attaque de pixel factice ;

une pluralité de premières lignes de balayage d'émission de lumière (EMk), où chacune des premières lignes de balayage d'émission de lumière (EMk) est connectée à l'un des premiers pixels factices (DPx1) et au circuit correspondant parmi les circuits de modulation de réparation (RMv) ;

une pluralité de secondes lignes de balayage d'émission de lumière (EMk+1) où chacune des secondes lignes de balayage d'émission de lumière (EMk+1) est connectée à l'un des seconds pixels factices (DPx2) ;

une ligne de signal factice (DL), où la ligne de signal factice (DL) est connectée à chacun des premiers pixels factices (DPx1) et à chacun des seconds pixels factices (DPx2) ;

une pluralité de premières lignes de balayage, où chacune des premières lignes de balayage est connectée à l'un des premiers pixels factices (DPx1) ;

une pluralité de secondes lignes de balayage, où chacune des secondes lignes de balayage est connectée à l'un des seconds pixels factices (DPx2) ;

une pluralité de premières lignes de balayage d'initialisation (Glk), où chacune des premières lignes de balayage d'initialisation est connectée à l'un des premiers pixels factices (DPx1) ;

une pluralité de deuxièmes lignes de balayage d'initialisation (Glk+1), où chacune des deuxièmes lignes de balayage d'initialisation est connectée à l'un des seconds pixels factices (DPx2) ;

une pluralité de troisièmes lignes de balayage d'initialisation (Gbk), où chacune des deuxièmes lignes de balayage d'initialisation est connectée à l'un des circuits de modulation de réparation (RMv) et à la rangée correspondante parmi les rangées paires de pixels (PX) ; et

une pluralité de quatrièmes lignes de balayage d'initialisation, où chacune des deuxièmes lignes de balayage d'initialisation est connectée à l'un des signaux de modulation de réparation et à la rangée correspondante parmi les rangées impaires de pixels ;

une ligne de signal factice (DL) s'étendant dans une direction de colonne, où la ligne de signal factice est connectée à chacun des premier et second circuits de pixel factice ;

une pluralité de lignes de données, où chacune des lignes de données est connectée aux pixels dans une colonne ;

où le premier circuit d'attaque de pixel factice est configuré pour délivrer en sortie un courant d'attaque correspondant à une tension de données d'un pixel sélectionné (PX) du dispositif d'affichage à OLED (10) sur la ligne de réparation (RPLk), lorsque le pixel sélectionné (PX) devient défectueux, sur la base d'un premier signal de commande d'émission de lumière,

où chaque circuit d'attaque de pixel comprend :

un transistor d'attaque de pixel (T1) ;
un premier transistor de commutation de pixel (T2) ;
un deuxième transistor de commutation de pixel (T3),
un troisième transistor de commutation de pixel (T4) ;
un quatrième transistor de commutation de pixel (T5) ;
un cinquième transistor de commutation de pixel (T6) ;
un sixième transistor de commutation de pixel (T7) ; et
un condensateur de pixel (Cst), le condensateur de pixel ayant une première borne et une seconde borne, la première borne étant connectée à la ligne de tension d'attaque ;

où chaque transistor possède une borne d'entrée, de sortie et de commande respective, et

où la borne de commande du transistor d'attaque de pixel est connectée à la seconde borne du condensateur de pixel, à l'entrée du deuxième transistor de commutation de pixel et à l'entrée du troisième transistor de commutation de pixel,

où les bornes de commande des premier et deuxième transistors de commutation de pixel sont connectées à l'une de la pluralité de premières lignes de balayage ou à l'une de la pluralité de secondes lignes de balayage,

où la borne de commande du troisième transistor de commutation de pixel est connectée à l'une de la pluralité de premières lignes d'initialisation de balayage ou à l'une de la pluralité de deuxièmes lignes d'initialisation de balayage,

où les bornes de commande des quatrième et cinquième transistors de commutation de pixel sont connectées à l'une de la pluralité de premières lignes d'émission ou à l'une de la pluralité de secondes lignes d'émission,

où la borne de commande du sixième transistor de commutation de pixel est connectée à l'une de la pluralité de troisièmes lignes d'initialisation de balayage ou à l'une de la pluralité de quatrièmes lignes d'initialisation de balayage,

où l'entrée du transistor d'attaque de pixel est connectée à la sortie du premier transistor de commutation de pixel et à la sortie du quatrième transistor de commutation de pixel,

où la sortie du transistor d'attaque de pixel est connectée à la sortie du deuxième transistor de commutation de pixel et à l'entrée du cinquième transistor de commutation de pixel,

où l'entrée du premier transistor de commutation de pixel est connectée à l'une de la pluralité de lignes de données,

où l'entrée du quatrième transistor de commutation de pixel est connectée à la ligne de tension d'attaque,

où la sortie du troisième transistor de commutation de pixel est connectée à la ligne de tension d'initialisation et à l'entrée du sixième transistor de commutation de pixel,

où les sorties des cinquième et sixième transistors de commutation de pixel sont connectées à l'anode de l'OLED ; et où une cathode de l'OLED est connectée à la ligne de tension commune, et

où chaque premier circuit d'attaque de pixel factice comprend :

un premier transistor d'attaque de pixel factice (T1) ;
un premier premier transistor de commutation de pixel factice (T2) ;
un deuxième premier transistor de commutation de pixel factice (T3),
un troisième premier transistor de commutation de pixel factice (T4) ;
un quatrième premier transistor de commutation de pixel factice (T5) ;
un cinquième premier transistor de commutation de pixel factice (T6) ; et
un premier condensateur factice (Cst), le premier condensateur factice ayant une première borne et une seconde borne, la première borne étant connectée à la ligne de tension d'attaque ;

où chaque premier transistor de pixel factice possède une borne d'entrée, de sortie et de commande respective, et

où la borne de commande du premier transistor d'attaque de pixel factice est connectée à la seconde borne du premier condensateur factice, à l'entrée du deuxième premier transistor de commutation de pixel factice et à l'entrée du troisième premier transistor de commutation de pixel factice,

où les bornes de commande des premier et deuxième premiers transistors de commutation de pixel factice sont connectées à l'une de la pluralité de premières lignes de balayage,

où la borne de commande du troisième premier transistor de commutation de pixel factice est connectée à l'une de la pluralité de premières lignes d'initialisation de balayage,

où les bornes de commande des quatrième et cinquième premiers transistors de pixel factice sont connectées à l'une de la pluralité de premières lignes d'émission,

où l'entrée du premier transistor d'attaque de pixel factice est connectée à la sortie du premier premier transistor de commutation de pixel factice et à la sortie du quatrième premier transistor de commutation de pixel factice,

où la sortie du premier transistor d'attaque de pixel factice est connectée à la sortie du deuxième premier transistor de commutation de pixel factice et à l'entrée du cinquième premier transistor de commutation de pixel factice,

où l'entrée du premier premier transistor de commutation de pixel factice est connectée à la ligne de signal factice,

où l'entrée du quatrième premier transistor de commutation de pixel factice est connectée à la ligne de tension d'attaque,

où la sortie du troisième premier transistor de commutation de pixel factice est connectée à la ligne d'initialisation de tension,

où la sortie du cinquième premier transistor de commutation de pixel factice est connectée à l'une de la pluralité de secondes lignes de réparation, et

où chaque second circuit d'attaque de pixel factice comprend :

un second transistor d'attaque de pixel factice (T1) ;
un premier second transistor de commutation de pixel factice (T2) ;
un deuxième second transistor de commutation de pixel factice (T3),
un troisième second transistor de commutation de pixel factice (T4) ;
un quatrième second transistor de commutation de pixel factice (T5) ;
un cinquième second transistor de commutation de pixel factice (T6) ; et
un second condensateur de pixel factice (Cst), le second condensateur de pixel factice ayant une première borne et une seconde borne, la première borne étant connectée à la ligne de tension d'attaque,

où chaque second transistor de pixel factice possède une borne d'entrée, de sortie et de commande respective, et

où la borne de commande du second transistor d'attaque de pixel factice est connectée à la seconde borne du second condensateur factice, à l'entrée du deuxième second transistor de commutation de pixel factice et à l'entrée du troisième second transistor de commutation de pixel factice,

où les bornes de commande des premier et deuxième seconds transistors de commutation de pixel factice sont connectées à l'une de la pluralité de secondes lignes de balayage,

où la borne de commande du troisième second transistor de commutation de pixel factice est connectée à l'une de la pluralité de deuxièmes lignes d'initialisation de balayage,

où les bornes de commande des quatrième et cinquième seconds transistors de pixel factice sont connectées à l'une de la pluralité de premières lignes d'émission,

où l'entrée du second transistor d'attaque de pixel factice est connectée à la sortie du premier second transistor de commutation de pixel factice et à la sortie du quatrième second transistor de commutation de pixel factice,

où la sortie du second transistor d'attaque de pixel factice est connectée à la sortie du deuxième second transistor de commutation de pixel factice et à l'entrée du cinquième second transistor de commutation de pixel factice,

où l'entrée du premier second transistor de commutation de pixel factice est connectée à la ligne de signal factice,

où l'entrée du quatrième second transistor de commutation de pixel factice est connectée à la ligne de tension d'attaque,

où la sortie du troisième second transistor de commutation de pixel factice est connectée à la ligne d'initialisation de tension, et

où la sortie du cinquième second transistor de commutation de pixel factice est connectée à l'une de la pluralité de secondes lignes de réparation,

où chacun des circuits de modulation de réparation (RMv) est connecté à l'une des premières lignes de réparation (RPLk), où chaque circuit de modulation de réparation (RMv) comprend :

> un condensateur de circuit de modulation de réparation, comprenant une première borne et une seconde borne ;
> un transistor de commutation de circuit de modulation de réparation (T8) ;
> un transistor d'initialisation (T9),

où chaque transistor comprend une borne d'entrée, de sortie et de commande,

où l'entrée du transistor de commutation de circuit de modulation de réparation est connectée à l'une de la pluralité de premières lignes de réparation,

où la borne de commande du transistor de commutation de circuit de modulation de réparation est connectée à l'une de la pluralité de premières lignes d'émission,

où la sortie du transistor de commutation de circuit de modulation de réparation est connectée à la seconde borne du condensateur de circuit de modulation de réparation et à l'entrée du transistor d'initialisation ;

où la borne de commande du transistor d'initialisation est connectée à l'une de la pluralité de troisièmes lignes d'initialisation de balayage, et

où la première borne du condensateur de circuit de modulation de réparation et la sortie du transistor d'initialisation sont connectées à la ligne d'initialisation de tension,

où le transistor de commutation de circuit de modulation de réparation est configuré pour être rendu passant ou bloqué en fonction d'un signal reçu à partir de la première ligne de commande d'émission, et

où les circuits de modulation de réparation (RMv) sont configurés pour :

> initialiser le condensateur avant que le courant d'attaque soit délivré en sortie du premier circuit d'attaque de pixel factice ;
> charger le condensateur du circuit de modulation de réparation (RMv) avec le courant d'attaque lorsque le courant d'attaque est délivré en sortie du premier circuit d'attaque de pixel factice, et
> partager le courant chargé avec une capacité parasite de la ligne de réparation (RPLk).

2. Dispositif d'affichage (10) selon la revendication 1, dans lequel le second circuit d'attaque de pixel factice est configuré pour appliquer un courant d'attaque correspondant à une première tension de données sur la ligne de réparation (RPLk) sur la base d'un second signal de commande d'émission de lumière, et dans lequel la première tension de données inclut une tension de données de gris noir, et dans lequel le courant d'attaque est de 0 A.

3. Dispositif d'affichage (10) selon la revendication 1, dans lequel le premier circuit d'attaque de pixel factice est configuré pour fournir le courant d'attaque à la ligne de réparation (RPLk) après que le transistor d'initialisation (T8, T9) a été rendu passant.

4. Procédé de réparation d'un dispositif d'affichage (10) selon une quelconque revendication précédente, le procédé comprenant les étapes consistant à :

> dans le pixel défectueux (BPX), déconnecter une OLED du pixel défectueux (BPX) par rapport à un circuit d'attaque de pixel du pixel défectueux (BPX) ;

connecter électriquement une ligne de réparation (RPLk) à une diode électroluminescente organique (OLED) d'un pixel défectueux (BPX) dans le dispositif d'affichage (10), où le circuit de modulation de réparation (RMv) inclut un condensateur ;
initialiser le condensateur d'un circuit de modulation de réparation respectif (RMv) ;
fournir un courant d'attaque correspondant à une tension de données du pixel défectueux (BPX) à la ligne de réparation (RPLk) dans le premier circuit d'attaque de pixel factice ;
charger le condensateur avec le courant d'attaque lorsque le courant d'attaque est délivré en sortie du premier circuit d'attaque de pixel factice ; et
partager le courant chargé du condensateur avec une capacité parasite du condensateur chargé et de la ligne de réparation (RPLk).

5. Procédé selon la revendication 4, comprenant en outre les étapes consistant à :

connecter électriquement le premier circuit d'attaque de pixel factice, le second circuit d'attaque de pixel factice et le circuit de modulation de réparation (RMv) à une sous-ligne de réparation (SRPL) ; et
partager le circuit de modulation de réparation (RMv) entre les premier et second circuits d'attaque de pixel factice.

6. Procédé selon la revendication 5, où le procédé comprend en outre l'étape consistant à appliquer un courant d'attaque correspondant à une première tension de données sur la ligne de réparation (RPLk) sur la base d'un second signal de commande d'émission de lumière, et où la première tension de données inclut une tension de données de gris noir.

7. Procédé selon la revendication 6, où l'initialisation du condensateur inclut le changement de la tension du premier signal d'initialisation d'un premier niveau à un second niveau de façon à rendre passant le transistor d'initialisation.

8. Procédé selon la revendication 7, où la fourniture du courant d'attaque à la ligne de réparation (RPLk) inclut la fourniture du courant d'attaque à la ligne de réparation (RPLk) via le premier circuit d'attaque de pixel factice après que le transistor d'initialisation a été rendu passant.

FIG. 1

FIG. 2

FIG. 3

FIG. 4

EP 3 093 836 B1

FIG. 5

FIG. 6

FIG. 7

FIG. 8

FIG. 9

FIG. 10

FIG. 11

**EP 3 093 836 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2998953 A2
- US 2015102312 A1